# EUROPEAN PATENT APPLICATION

(11) **EP 4 568 428 A1**
(43) Date of publication of application: **11.06.2025**
(21) Application number: 24215250.2
(22) Date of filing: 25.11.2024
(51) Int. Cl.: H05K 1/02, H05K 1/14, H01R 12/52, H01R 12/71, H01R 13/648, H05K 3/36

(54) **CIRCUIT BOARD UNIT AND ELECTRONIC INSTRUMENT**

(30) Priority: 27.11.2023 JP 2023199657
(71) Applicant: Seiko Epson Corporation, Tokyo 160-8801 (JP)
(72) Inventor: ITO, Masaaki, 392-8502 Suwa-shi (JP); OMORI, Toshiyuki, 392-8502 Suwa-shi (JP); ARICHIKA, Yusuke, 392-8502 Suwa-shi (JP); OTSUKI, Nobuyuki, 392-8502 Suwa-shi (JP)
(74) Representative: Lewis Silkin LLP

(57) **Abstract**

A circuit board unit 60 includes a first circuit board 61, a second circuit board 62, a connector unit 70 including a first connector 71 attached to the first circuit board and a second connector 72 attached to the second circuit board, and a metal member 80 that couples the first circuit board and the second circuit board to each other. The metal member includes a first coupling section electrically coupled to a first ground layer of the first circuit board, a second coupling section electrically coupled to a second ground layer of the second circuit board, and a cover section 80a that covers at least a part of the connector unit. The cover section includes a facing wall section 81 at least a part of which faces the connector unit in a direction perpendicular to plate surfaces of the first circuit board. The facing wall section overlaps with the first circuit board when viewed in the direction perpendicular to the plate surfaces of the first circuit board, and overlaps with the second circuit board when viewed in a direction perpendicular to plate surfaces of the second circuit board.

## Description

The present application is based on, and claims priority from JP Application Serial Number 2023-199657, filed November 27, 2023, the disclosure of which is hereby incorporated by reference herein in its entirety.

### BACKGROUND

### 1. Technical Field

The present disclosure relates to a circuit board unit and an electronic instrument.

### 2. Related Art

For example, there is a known board coupling structure that couples printed circuit boards to each other, such as the structure described in JP-A-2011-222405.

JP-A-2011-222405 is an example of the related art.

In the board coupling structure described above, when a signal such as a high-frequency signal flows from one printed circuit board to the other printed circuit board, unwanted radiation noise, that is, electromagnetic noise is likely to be produced, and it is required to suppress the unwanted radiation noise. The board coupling structure described in JP-A-2011-222405, to suppress the flow of electrostatic discharge noise applied from an external connector to the one printed circuit board to an inter-board connector, is provided with a conduction member that couples a portion of a ground layer located at the periphery of the one printed circuit board, which is a portion distant from the inter-board connector, to a ground layer of the other printed circuit board. The solution described above, that is, providing the conductive member, however, has a problem of failure in suppression of the unwanted radiation noise caused by a signal flowing through the inter-board connector.

### SUMMARY

A circuit board unit according to an aspect of the present disclosure includes a first circuit board including a first ground layer; a second circuit board including a second ground layer; a connector unit including a first connector attached to the first circuit board and a second connector attached to the second circuit board; and a metal member configured to couple the first circuit board and the second circuit board to each other. The metal member includes a first coupling section electrically coupled to the first ground layer, a second coupling section electrically coupled to the second ground layer, and a cover section configured to cover at least a part of the connector unit. The cover section includes a facing wall section at least a part of which faces the connector unit in a direction perpendicular to plate surfaces of the first circuit board. The facing wall section overlaps with the first circuit board when viewed in the direction perpendicular to the plate surfaces of the first circuit board, and overlaps with the second circuit board when viewed in a direction perpendicular to plate surfaces of the second circuit board.

An electronic apparatus according to an aspect of the present disclosure includes the circuit board unit described above.

### BRIEF DESCRIPTION OF THE DRAWINGS

FIG. 1 is a schematic configuration diagram showing a projector in a first embodiment.
FIG. 2 is a perspective view showing a part of a circuit board unit according to the first embodiment.
FIG. 3 is a plan view showing a part of the circuit board unit according to the first embodiment.
FIG. 4 is a cross-sectional view showing a part of the circuit board unit according to the first embodiment and taken along the line IV-IV in FIG. 3.
FIG. 5 is a cross-sectional view showing a part of the circuit board unit according to the first embodiment and taken along the line V-V in FIG. 3.
FIG. 6 is a perspective view showing a part of a metal member in the first embodiment.
FIG. 7 is a cross-sectional view showing a metal member in a second embodiment.
FIG. 8 is a perspective view showing a part of a circuit board unit according to a third embodiment.
FIG. 9 is a cross-sectional view showing a part of the circuit board unit according to the third embodiment.
FIG. 10 is a cross-sectional view showing a part of a circuit board unit according to a fourth embodiment.
FIG. 11 is a perspective view showing a part of a circuit board unit according to a fifth embodiment.
FIG. 12 is a plan view showing a part of the circuit board unit according to the fifth embodiment.
FIG. 13 is a cross-sectional view showing a part of the circuit board unit according to the fifth embodiment and taken along line XIII-XIII in FIG.12.
FIG. 14 is a perspective view showing a part of a circuit board unit according to a sixth embodiment.
FIG. 15 is a cross-sectional view sowing a part of the circuit board unit according to the sixth embodiment.

### DESCRIPTION OF EMBODIMENTS

Embodiments of the present disclosure will be described below with reference to the drawings. The following embodiments will be described with reference to a projector as an electronic instrument.

The scope of the present disclosure is not limited to the following embodiments, and can be changed in any manner within the scope of the technical idea of the present disclosure. In the following drawings, for clarity of each configuration, the scale, the number, and other factors of the structure of the configuration differ from those of an actual structure in some cases.

### First embodiment

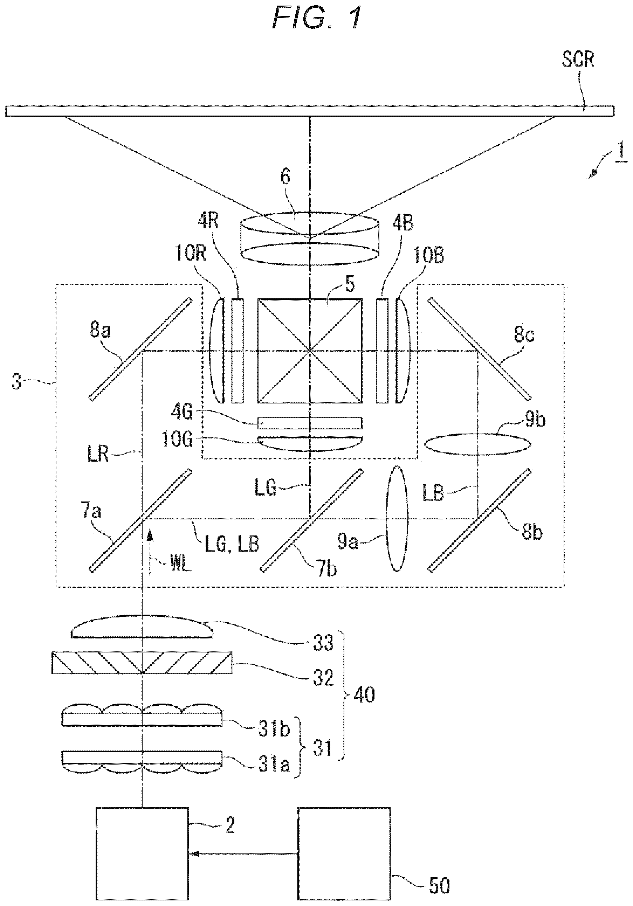

FIG. 1 is a schematic configuration diagram showing a projector 1 as an electronic instrument according to the present embodiment.

The projector 1 in the present embodiment is a projection-type image display apparatus that projects a color image onto a screen SCR. The projector 1 includes a light source apparatus 2, a homogenized illumination system 40, a color separation system 3, light modulators 4R, 4G, and 4B, a light combining system 5, a projection optical apparatus 6, and a controller 50, as shown in FIG. 1. The light source apparatus 2 outputs illumination light WL toward the homogenized illumination system 40.

The homogenized illumination system 40 includes an optical integration system 31, a polarization converter 32, and a superimposing system 33. The optical integration system 31 includes a first lens array 31a and a second lens array 31b. The homogenized illumination system 40 homogenizes the intensity distribution of the illumination light WL output from the light source apparatus 2 at each of the light modulators 4R, 4G, and 4B, which are illumination receiving regions. The illumination light WL output from the homogenized illumination system 40 enters the color separation system 3.

The color separation system 3 separates the illumination light WL, which is white light, into red light LR, green light LG, and blue light LB. The color separation system 3 includes a first dichroic mirror 7a, a second dichroic mirror 7b, a first reflection mirror 8a, a second reflection mirror 8b, a third reflection mirror 8c, a first relay lens 9a, and a second relay lens 9b.

The first dichroic mirror 7a separates the illumination light WL from the light source apparatus 2 into the red light LR and the other light, that is, the green light LG and the blue light LB. The first dichroic mirror 7a transmits the separated red light LR and reflects the other light, that is, the green light LG and the blue light LB. The second dichroic mirror 7b separates the other light into the green light LG and the blue light LB. The second dichroic mirror 7b reflects the separated green light LG and transmits the separated blue light LB.

The first reflection mirror 8a is disposed in the optical path of the red light LR and reflects the red light LR having passed through the first dichroic mirror 7a toward the light modulator 4R. The second reflection mirror 8b and the third reflection mirror 8c are disposed in the optical path of the blue light LB and reflect the blue light LB having passed through the second dichroic mirror 7b to the light modulator 4B. The green light LG is reflected off the second dichroic mirror 7b toward the light modulator 4G.

The first relay lens 9a and the second relay lens 9b are disposed in the optical path of the blue light LB at positions facing the light exiting side of the second dichroic mirror 7b. The first relay lens 9a and the second relay lens 9b correct the difference in illumination distribution of the blue light LB due to the fact that the optical path length of the blue light LB is longer than the optical path length of the red light LR and the optical path length of the green light LG.

The light modulator 4R modulates the red light LR in accordance with image information to form image light corresponding to the red light LR. The light modulator 4G modulates the green light LG in accordance with image information to form image light corresponding to the green light LG. The light modulator 4B modulates the blue light LB in accordance with image information to form image light corresponding to the blue light LB.

The light modulators 4R, 4G, and 4B are each, for example, a transmissive liquid crystal panel. Polarizers that are not shown are disposed on the light incident side and the light exiting side of each of the liquid crystal panels to allow only light linearly polarized in a specific direction to pass through the liquid crystal panel.

Field lenses 10R, 10G, and 10B are disposed at the light incident side of the light modulators 4R, 4G, and 4B, respectively. The field lenses 10R, 10G, and 10B parallelize the chief rays of the red light LR, the green light LG, and the blue light LB to be incident on the light modulators 4R, 4G, and 4B, respectively.

When the image light output from the light modulator 4R, the image light output from the light modulator 4G, and the image light output from the light modulator 4B enter the light combining system 5, the light combining system 5 combines the image light corresponding to the red light LR, the image light corresponding to the green light LG, and the image light corresponding to the blue light LB with one another and outputs the combined image light toward the projection optical apparatus 6. For example, a cross dichroic prism is used to form the light combining system 5.

The projection optical apparatus 6 is configured with multiple projection lenses. The projection optical apparatus 6 enlarges the combined image light from the light combining system 5 and projects the enlarged image light toward the screen SCR. An image is thus displayed on the screen SCR.

The controller 50 will next be described.

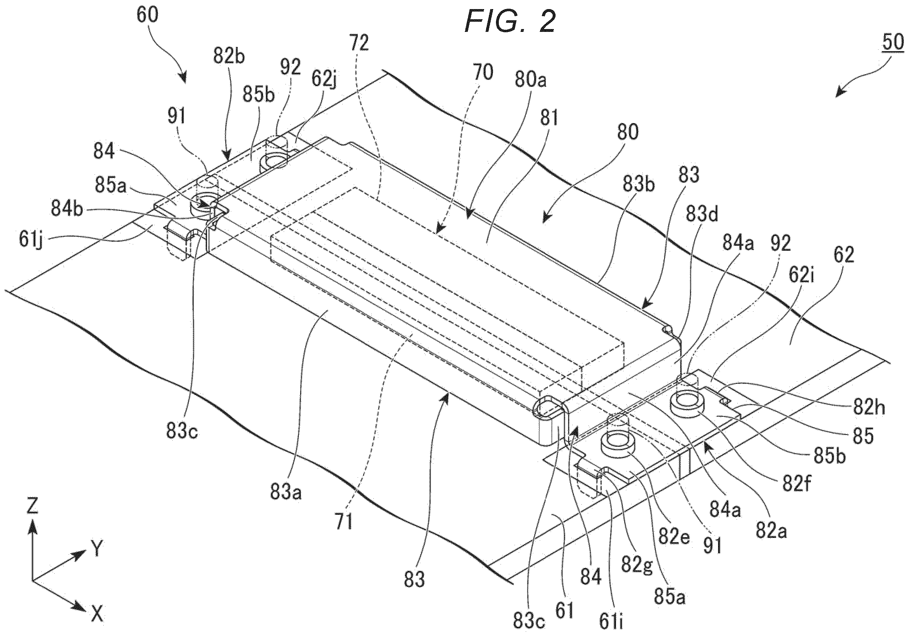

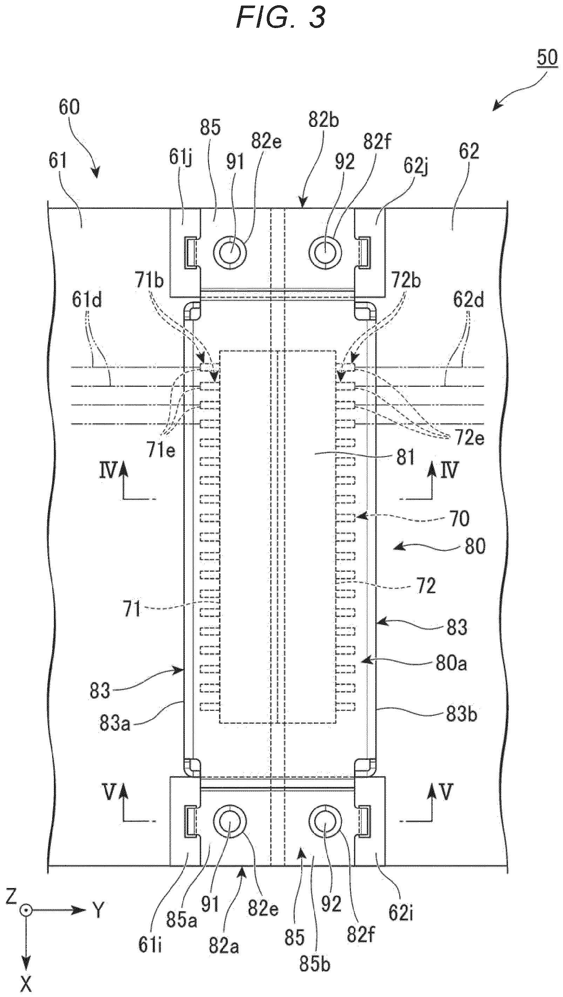

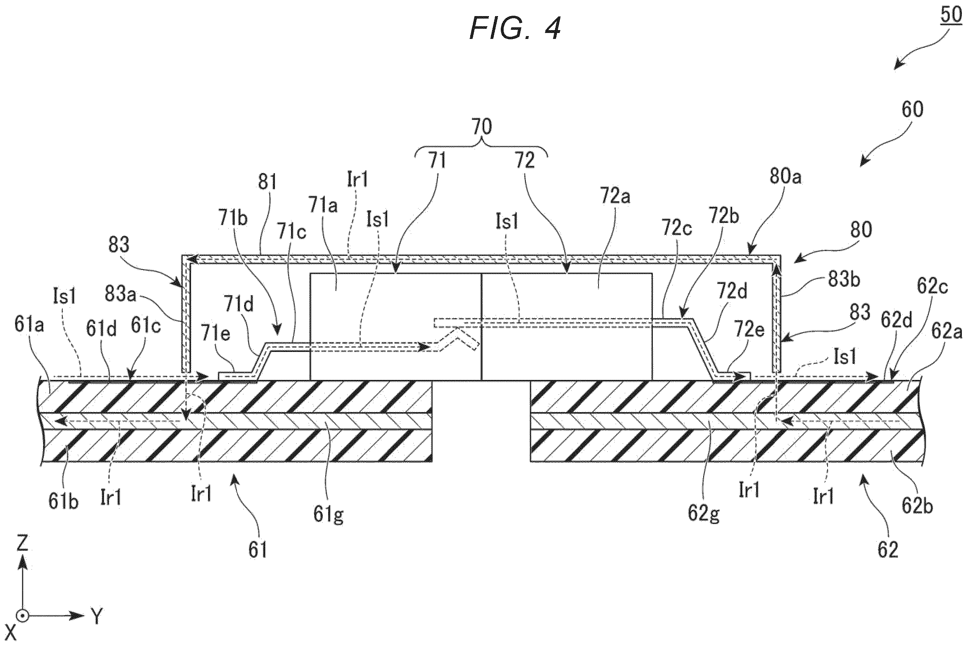

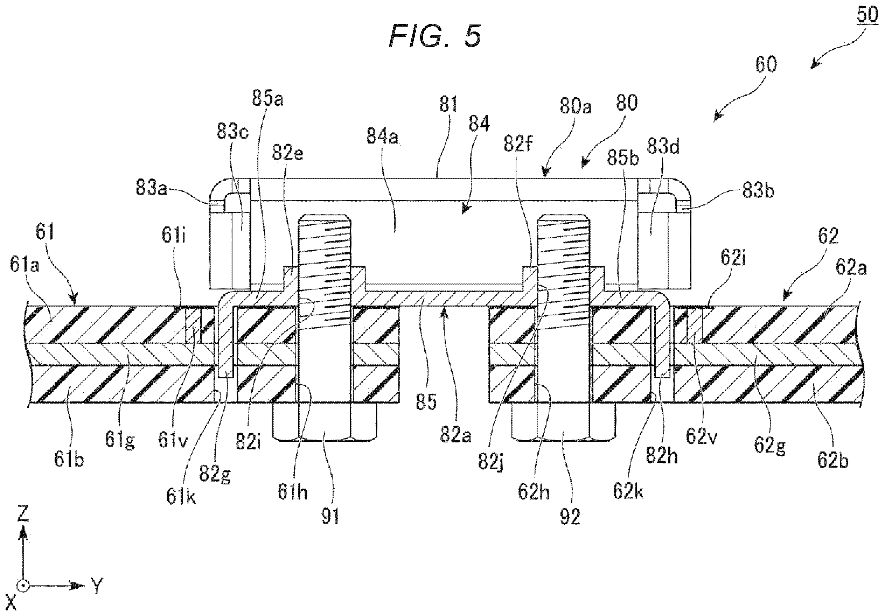

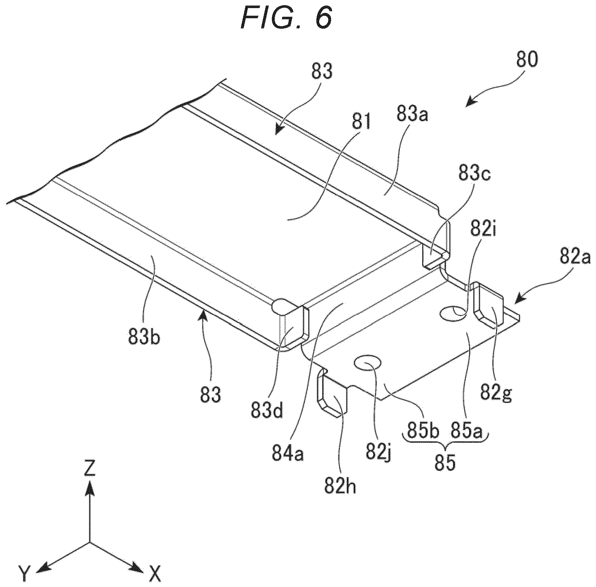

FIG. 2 is a perspective view showing a part of a circuit board unit 60 in the controller 50. FIG. 3 is a plan view showing a part of the circuit board unit 60. FIG. 4 is a cross-sectional view showing a part of the circuit board unit 60 and taken along the line IV-IV in FIG. 3. Note that FIG. 4 does not show a cross section of a connector unit 70, which will be described later. FIG. 5 is a cross-sectional view showing a part of the circuit board unit 60 and taken along the line V-V in FIG. 3. FIG. 6 is a perspective view showing a part of a metal member 80, which will be described later.

The figures each show an X-axis, a Y-axis, and a Z-axis as appropriate. A direction parallel to the X-axis is called a "first horizontal direction X", a direction parallel to the Y-axis is called a "second horizontal direction Y", and a direction parallel to the Z-axis is called an "upward-downward direction Z". The first horizontal direction X, the second horizontal direction Y, and the upward-downward direction Z are directions perpendicular to each other. Out of the two sides in the upward-downward direction Z, the side to which the arrow of the Z axis points, that is, the +Z side is called an "upper side", and the side opposite the side to which the arrow of the Z axis points, that is, the -Z side is called a "lower side". Out of the two sides in the first horizontal direction X, the side to which the arrow of the X-axis points, that is, the +X side is called "one side in the first horizontal direction", and the side opposite the side to which the arrow of the X-axis points, that is, the -X side is called "the other side in the first horizontal direction". Out of the two sides in the second horizontal direction Y, the side to which the arrow of the Y-axis points, that is, the +Y side is called "one side in the second horizontal direction", and the side opposite the side to which the arrow of the Y-axis points, that is, the -Y side is called "the other side in the second horizontal direction".

Note that the upward-downward direction Z, the first horizontal direction X, and the second horizontal direction Y are names for simply describing, for example, the relative positional relationship between portions, and the actual arrangement and the like may differ from the arrangement and the like called by the names.

The controller 50 is a main board that controls each portion of the projector 1 including the light source apparatus 2. The controller 50 includes the circuit board unit 60, as shown in FIGS. 2 to 5. The circuit board unit 60 includes a first circuit board 61, a second circuit board 62, and the connector unit 70, as shown in FIG. 2. The first circuit board 61 and the second circuit board 62 are electrically coupled to each other via the connector unit 70. In the present embodiment, the first circuit board 61 and the second circuit board 62 each have the shape of a plate having plate surfaces facing the two sides in the upward-downward direction Z and extends along the first horizontal direction X and the second horizontal direction Y. The plate surfaces of the first circuit board 61 and the plate surfaces of the second circuit board 62 are perpendicular to the upward-downward direction Z.

In the present embodiment, the upward-downward direction Z corresponds to a "first direction" perpendicular to the plate surfaces of the first circuit board 61, the second horizontal direction Y corresponds to a "second direction" perpendicular to the first direction, and the first horizontal direction X corresponds to a "third direction" perpendicular to both the first direction and the second direction.

In the present embodiment, the plate surfaces of the first circuit board 61 and the plate surfaces of the second circuit board 62 are parallel to each other. Note in the present specification that the expression "certain targets are parallel to each other" includes a case where the certain targets are strictly parallel to each other and also includes a case where the certain targets are substantially parallel to each other. For example, the case in which the certain targets are substantially parallel to each other includes a case in which one target inclines with respect to the other target by about 15° or smaller.

In the present embodiment, the first circuit board 61 and the second circuit board 62 are arranged side by side in the direction along the plate surfaces of the first circuit board 61 and the plate surfaces of the second circuit board 62, as shown in FIG. 3. In the present embodiment, the first circuit board 61 and the second circuit board 62 are arranged side by side in the second horizontal direction Y. The first circuit board 61 and the second circuit board 62 are disposed separate from each other in the second horizontal direction Y. In the present embodiment, the first circuit board 61 and the second circuit board 62 are disposed at the same position in the upward-downward direction Z.

In the present embodiment, the first circuit board 61 and the second circuit board 62 are each a printed circuit board provided with wiring patterns made of copper foil. The first circuit board 61 and the second circuit board 62 are boards having the same structure. In the following description, when some of the configurations of the first circuit board 61 and the second circuit board 62 are the same, description of the same configurations about the second circuit board 62 will be partially omitted in some cases.

The first circuit board 61 includes first insulating layers 61a and 61b, a first wiring layer 61c, and a first ground layer 61g, as shown in FIG. 4. The first insulating layer 61a is layered at the upper side of the first ground layer 61g. The first insulating layer 61b is layered at the lower side of the first ground layer 61g. The first wiring layer 61c is layered at the upper side of the first insulating layer 61a. The first wiring layer 61c is a layer configured with multiple wiring patterns made of copper foil. The first wiring layer 61c includes signal lines 61d electrically coupled to a first connector 71. The signal lines 61d extend in the second horizontal direction Y, as shown in FIG. 3. The signal lines 61d are provided in multiple and arranged in the first horizontal direction X. The multiple signal lines 61d include a signal line 61d through which a high-frequency signal flows. The high-frequency signal is, for example, a signal having a frequency of 20 MHz or higher. FIG. 3 shows only some of the multiple signal lines 61d.

Although not shown, the first wiring layer 61c is covered, for example, with a resist layer except for portions to which electronic elements mounted on the upper surface of the first circuit board 61 are electrically coupled. The upper surface of the first circuit board 61 is formed by the upper surface of the first wiring layer 61c, the upper surface of the resist layer, and first ground pads 61i and 61j, which will be described later. In the present embodiment, the upper surface of the first circuit board 61 is an upper plate surface of the first circuit board 61, and is a mounting surface to which electronic elements and other parts are attached.

In the present embodiment, the first ground layer 61g is an inner layer that configures a portion of the first circuit board 61, as shown in FIG. 4. The first ground layer 61g is a layer having a potential that is a reference potential in the circuit board unit 60. The first ground layer 61g is configured, for example, with a solid pattern made of copper foil. The first ground layer 61g is also called a reference plane.

The pair of first ground pads 61i and 61j are formed at the upper surface of the first circuit board 61, as shown in FIG. 3. The pair of first ground pads 61i and 61j are provided with a gap therebetween in the first horizontal direction X. The first ground pad 61i is located at a position shifted from the first ground pad 61j toward the one side in the first horizontal direction, that is, the +X side. In the present embodiment, the first ground pads 61i and 61j each have a rectangular shape when viewed in the upward-downward direction Z. In the present embodiment, the first ground pad 61i is provided in the same layer in which the first wiring layer 61c is provided, and is electrically coupled to the first ground layer 61g via a via 61v formed in the first insulating layer 61a, as shown in FIG. 5. Although not shown, the first ground pad 61j is also electrically coupled to the first ground layer 61g as the first ground pad 61i. Note that the pair of first ground pads 61i and 61j may each be a portion of the first ground layer 61g that is exposed at the upper surface of the first circuit board 61 via an opening formed in the first insulating layer 61a.

The second circuit board 62 is disposed at a position shifted from the first circuit board 61 toward the one side in the second horizontal direction, that is, the +Y side with a gap between the two circuit boards. The second circuit board 62 includes second insulating layers 62a and 62b, a second wiring layer 62c, and a second ground layer 62g, as shown in FIG. 4. The second insulating layers 62a and 62b, the second wiring layer 62c, and the second ground layer 62g are similar to the first insulating layers 61a and 61b, the first wiring layer 61c, and the first ground layer 61g of the first circuit board 61, respectively. The second wiring layer 62c includes signal lines 62d electrically coupled to a second connector 72. The signal lines 62d extend in the second horizontal direction Y, as shown in FIG. 3. The signal lines 62d are provided in multiple and arranged in the first horizontal direction X. The multiple signal lines 62d include a signal line 62d through which a high-frequency signal flows. The high-frequency signal is, for example, a signal having a frequency of 20 MHz or higher. FIG. 3 shows only some of the multiple signal lines 62d.

A pair of second ground pads 62i and 62j are formed at the upper surface of the second circuit board 62, as shown in FIG. 3. The pair of second ground pads 62i and 62j are provided with a gap therebetween in the first horizontal direction X. The pair of second ground pads 62i and 62j are similar to the pair of first ground pads 61i and 61j, respectively. The pair of first ground pads 61i and 61j and the pair of second ground pads 62i and 62j are so arranged that the first ground pad 61i and the second ground pad 62i, and the first ground pad 61j and the second ground pad 62j are both separate from each other in the second horizontal direction Y. The second ground pad 62i is provided in the same layer in which the second wiring layer 62c is provided, and is electrically coupled to the second ground layer 62g via a via 62v formed in the second insulating layer 62a, as shown in FIG. 5. Although not shown, the second ground pad 62j is also electrically coupled to the second ground layer 62g as the second ground pad 62i. The pair of second ground pads 62i and 62j may each be a portion of the second ground layer 62g that is exposed at the upper surface of the second circuit board 62 via an opening formed in the second insulating layer 62a.

The connector unit 70 relays signal transmission between the first circuit board 61 and the second circuit board 62. In the present embodiment, the connector unit 70 has a substantially rectangular shape elongated in the first horizontal direction X when viewed in the upward-downward direction Z, as shown in FIG. 3. Note that FIG. 2 does not show first couplers 71b or second couplers 72b, which will be described later, and diagrammatically shows the connector unit 70.

The connector unit 70 includes the first connector 71 and the second connector 72, as shown in FIG. 4. The first connector 71 is attached to the upper surface of the first circuit board 61. The second connector 72 is attached to the upper surface of the second circuit board 62. The first connector 71 and the second connector 72 are coupled to each other in the second horizontal direction Y. That is, in the present embodiment, the direction in which the first connector 71 and the second connector 72 are coupled to each other is the second horizontal direction Y.

In the present embodiment, the first connector 71 is a female connector, and the second connector 72 is a male connector. The first connector 71 and the second connector 72 are fitted to each other in the second horizontal direction Y and electrically coupled to each other. That is, in the present embodiment, the direction in which the first connector 71 and the second connector 72 are fitted to each other is the second horizontal direction Y.

The first connector 71 includes a first housing 71a and multiple first couplers 71b. The first housing 71a is a member that is made of resin and holds the multiple first couplers 71b. The first housing 71a is created, for example, by insert molding using the multiple first couplers 71b as insert members. The first housing 71a has the shape of a substantially rectangular box. The first housing 71a is in contact with the upper surface of the first circuit board 61. Note that the first housing 71a may be disposed so as to be separate upward from the upper surface of the first circuit board 61. The first housing 71a protrudes toward the one side in the second horizontal direction, that is, the +Y side beyond the first circuit board 61. The first housing 71a is a holder that holds the multiple first couplers 71b.

The multiple first couplers 71b are held by the first housing 71a. A part of each of the first couplers 71b is buried in the first housing 71a. The first couplers 71b are each a member made of metal and having the shape of an elongated plate. The multiple first couplers 71b are arranged at intervals in the first horizontal direction X, as shown in FIG. 3. The first couplers 71b each include a first extending section 71c, a second extending section 71d, and a board connecting section 71e, as shown in FIG. 4.

The first extending section 71c extends in the second horizontal direction Y. An end portion of the first extending section 71c at the one side in the second horizontal direction, that is, the +Y side is exposed in a recess that is not shown but is formed in the first housing 71a and opens toward the one side in the second horizontal direction. An end portion of the first extending section 71c at the other side in the second horizontal direction, that is, the -Y side protrudes from the first housing 71a toward the other side in the second horizontal direction and is exposed to the exterior of the first housing 71a. The first couplers 71b of the first connector 71 thus protrude from the first housing 71a in the second horizontal direction Y.

The second extending section 71d extends from the end of the first extending section 71c at the other side in the second horizontal direction, that is, the -Y side obliquely downward toward the other side in the second horizontal direction. The board connecting section 71e extends from the lower end of the second extending section 71d toward the other side in the second horizontal direction. The board connecting section 71e is electrically coupled to the first circuit board 61. The first couplers 71b are thus electrically coupled to the first circuit board 61. The board connecting sections 71e of the multiple first couplers 71b are electrically coupled to the multiple signal lines 61d, respectively, as shown in FIG. 3. In more detail, the board connecting sections 71e are in contact with portions of the signal lines 61d that are exposed at the upper surface of the first circuit board 61, and are electrically coupled to the signal lines 61d.

The second connector 72 is located at a position shifted form the first connector 71 toward the one side in the second horizontal direction, that is, the +Y side, as shown in FIG. 4. The second connector 72 includes a second housing 72a and multiple second couplers 72b. The second housing 72a is a member that is made of resin and holds the multiple second couplers 72b. The second housing 72a is created, for example, by insert molding using the multiple second couplers 72b as insert members. The second housing 72a has the shape of a substantially rectangular box. The second housing 72a is in contact with the upper surface of the second circuit board 62. Note that the second housing 72a may be disposed so as to be separate upward from the upper surface of the second circuit board 62. The second housing 72a protrudes toward the other side in the second horizontal direction, that is, the -Y side beyond the second circuit board 62. The second housing 72a is a holder that holds the multiple second couplers 72b.

The multiple second couplers 72b are held by the second housing 72a. A part of each of the second couplers 72b is buried in the second housing 72a. The second couplers 72b are each a member made of metal and having the shape of an elongated plate. The multiple second couplers 72b are arranged at intervals in the first horizontal direction X, as shown in FIG. 3. The multiple second couplers 72b are shifted from the multiple first couplers 71b toward the one side in the second horizontal direction, that is, the +Y side in correspondence with the respective multiple first couplers 71b.

The second couplers 72b each include a first extending section 72c, a second extending section 72d, and a board connecting section 72e, as shown in FIG. 4. The first extending section 72c extends in the second horizontal direction Y. An end portion of the first extending portion 72c that is at the other side in the second horizontal direction is inserted into a recess that is not shown but is formed in the first housing 71a, and is in contact with the first extending section 71c of the corresponding first coupler 71b exposed in the recess. The first couplers 71b and the second couplers 72b are thus electrically coupled to each other. An end portion of the first extending section 72c at the one side in the second horizontal direction, that is, the +Y side protrudes from the second housing 72a toward the one side in the second horizontal direction and is exposed to the exterior of the second housing 72a. The second couplers 72b of the second connector 72 thus protrude from the second housing 72a in the second horizontal direction Y.

The second extending section 72d extends from the end portion of the first extending section 72c at the one side in the second horizontal direction, that is, the +Y side obliquely downward toward the one side in the second horizontal direction. The board connecting section 72e extends from the lower end of the second extending section 72d toward the one side in the second horizontal direction. The board connecting section 72e is electrically coupled to the second circuit board 62. The second couplers 72b are thus electrically coupled to the second circuit board 62. The board connecting sections 72e of the multiple second couplers 72b are electrically coupled to the multiple signal lines 62d, respectively, as shown in FIG. 3. In more detail, the board connecting sections 72e are in contact with portions of the signal lines 62d that are exposed at the upper surface of the second circuit board 62, and are electrically coupled to the signal lines 62d.

The circuit board unit 60 includes the metal member 80, which couples the first circuit board 61 and the second circuit board 62 to each other. The metal member 80 electrically couples the first ground layer 61g and the second ground layer 62g to each other. In the present embodiment, the metal member 80 is a sheet metal member, as shown in FIGS. 2 and 6. The metal member 80 is created by pressing a sheet metal. The material of which the metal member 80 is made is not limited to a specific material and may be any metal. The metal member 80 may be replaced with an electrically conductive member made, for example, of carbon.

The metal member 80 includes a cover section 80a and a pair of fixing sections 82a and 82b, as shown in FIG. 2. The cover section 80a is a portion that covers at least a part of the connector unit 70. In the present embodiment, the cover section 80a has the shape of a substantially rectangular box that opens downward. The connector unit 70 is caped with the cover section 80a from above. The cover section 80a covers the connector unit 70 from the upper side, opposite sides in the first horizontal direction X, and opposite sides in the second horizontal direction Y. The cover section 80a covers from above at least a part of the gap in the second horizontal direction Y between the first circuit board 61 and the second circuit board 62. The cover section 80a includes a facing wall section 81, protruding wall sections 83, coupling wall sections 84, and bent sections 83c and 83d.

The facing wall section 81 has the shape of a plate having plate surfaces facing the opposite sides in the upward-downward direction Z. The plate surfaces of the facing wall section 81 are perpendicular to the upward-downward direction Z. In the present embodiment, the facing wall section 81 has the shape of a substantially rectangular plate elongated in the first horizontal direction X. The facing wall section 81 is located above the connector unit 70. At least a part of the facing wall section 81 faces the connector unit 70 in the direction perpendicular to the plate surfaces of the first circuit board 61, that is, the upward-downward direction Z. In the present embodiment, substantially the entire facing wall section 81 except for opposite edge portions in the first horizontal direction X and opposite edge portions in the second horizontal direction Y faces the connector unit 70 in the upward-downward direction Z. The facing wall section 81 has a portion facing the first connector 71 in the upward-downward direction Z and a portion facing the second connector 72 in the upward-downward direction Z. The facing wall section 81 faces the first housing 71a, the first couplers 71b, the second housing 72a, and the second couplers 72b in the upward-downward direction Z.

The facing wall section 81 covers at least a part of the connector unit 70 from above. In the present embodiment, the facing wall section 81 has a portion that covers the first connector 71 from above and a portion that covers the second connector 72 from above. In the present embodiment, the facing wall section 81 covers the entire connector unit 70 from above. The facing wall section 81 overlaps the connector unit 70 when viewed in the upward-downward direction Z, and further has a portion that overlaps with the first circuit board 61 and a portion that overlaps with the second circuit board 62. In other words, the facing wall section 81 overlaps with the first circuit board 61 when viewed in the direction perpendicular to the plate surfaces of the first circuit board 61, and overlaps with the second circuit board 62 when viewed in the direction perpendicular to the plate surfaces of the second circuit board 62. The edge portion of the facing wall section 81 at the other side in the second horizontal direction, that is, the -Y side is located above the first circuit board 61. The edge portion of the facing wall section 81 at the one side in the second horizontal direction, that is, the +Y side is located above the second circuit board 62.

The end portion of the facing wall section 81 at the other side in the second horizontal direction, that is, the -Y side is shifted from end portions of the first couplers 71b at the other side in the second horizontal direction toward the other side in the second horizontal direction, as shown in FIG. 4. In other words, the end portion of the facing wall section 81 at the side where the first couplers 71b protrude from the first housing 71a, that is, the -Y side is located outside the end portions of the first couplers 71b at the side where the first couplers 71b protrude from the first housing 71a. In the present embodiment, the end portions of the first couplers 71b at the other side in the second horizontal direction are end portions of the board connecting sections 71e at other side in the second horizontal direction.

The end portion of the facing wall section 81 at the one side in the second horizontal direction, that is, the +Y side is shifted from end portions of the second couplers 72b at the one side in the second horizontal direction toward the one side in the second horizontal direction. In other words, the end portion of the facing wall section 81 at the side where the second couplers 72b protrude from the second housing 72a, that is, the +Y side is located outside the end portions of the second couplers 72b at the side where the second couplers 72b protrude from the second housing 72a. In the present embodiment, the end portions of the second couplers 72b at the one side in the second horizontal direction are end portions of the board connecting sections 72e at one side in the second horizontal direction.

The shortest distance in the upward-downward direction Z between the facing wall section 81 and the connector unit 70 is, for example, smaller than the dimension of the connector unit 70 in the upward-downward direction Z. The dimension of the connector unit 70 in the upward-downward direction Z is, for example, equal to each of the dimension of the first connector 71 in the upward-downward direction Z and the dimension of the second connector 72 in the upward-downward direction Z. The shortest distance in the upward-downward direction Z between the facing wall section 81 and the connector unit 70 is, for example, smaller than the distance in the second horizontal direction Y between the first circuit board 61 and the second circuit board 62. The shortest distance in the upward-downward direction Z between the facing wall section 81 and the connector unit 70 is, for example, greater than or equal to about 0.5 mm but smaller than or equal to about 20 mm. The shortest distance in the upward-downward direction Z between the facing wall section 81 and the connector unit 70 is preferably, for example, smaller than 10 mm. In the present embodiment, the shortest distance in the upward-downward direction Z between the facing wall section 81 and the connector unit 70 is the distance in the upward-downward direction Z between the lower surface of the facing wall section 81 and the upper surface of the first housing 71a and the distance in the upward-downward direction Z between the lower surface of the facing wall section 81 and the upper surface of the second housing 72a.

The protruding wall sections 83 each protrude from the facing wall section 81 toward the corresponding one of the first circuit board 61 and the second circuit board 62. In the present embodiment, the protruding wall sections 83 each have the shape of a plate having plate surfaces facing the opposite sides in the second horizontal direction Y. The plate surfaces of each of the protruding wall sections 83 are perpendicular to the second horizontal direction Y. In the present embodiment, the protruding wall sections 83 each have the shape of a substantially rectangular plate elongated in the first horizontal direction X, as shown in FIG. 2. The dimension of each of the protruding wall sections 83 in the first horizontal direction X is smaller than the dimension of the facing wall section 81 in the first horizontal direction X. In the present embodiment, the protruding wall sections 83 are portions bent in the upward-downward direction Z at the edge portions of the facing wall section 81 that face the opposite sides in the second horizontal direction Y.

In the present embodiment, the protruding wall sections 83 are configured with a pair of protruding wall section 83a (first protruding wall section) and a protruding wall section 83b (second protruding wall section). The protruding wall section 83a protrudes downward from the edge portion of the facing wall section 81 at the other side in the second horizontal direction, that is, the -Y side toward the first circuit board 61. The protruding wall section 83b protrudes downward from the edge portion of the facing wall section 81 at the one side in the second horizontal direction, that is, the +Y side toward the second circuit board 62. The pair of protruding wall sections 83a and 83b are provided to sandwich the connector unit 70 in the second horizontal direction Y, as shown in FIG. 4. The pair of protruding wall sections 83a and 83b face the connector unit 70 in the second horizontal direction Y. The protruding wall section 83a is located away from the first connector 71 toward the other side in the second horizontal direction, and faces the first connector 71 with a gap therebetween. The protruding wall section 83a covers at least a part of the first connector 71 at the other side in the second horizontal direction. In the present embodiment, the protruding wall section 83a covers substantially the entire first connector 71 except for a lower end portion at the other side in the second horizontal direction. The protruding wall section 83b is located away from the second connector 72 toward the one side in the second horizontal direction, and faces the second connector 72 with a gap therebetween. The protruding wall section 83b covers at least a part of the second connector 72 at the one side in the second horizontal direction. In the present embodiment, the protruding wall section 83b covers substantially the entire second connector 72 except for a lower end portion at the one side in the second horizontal direction.

In the present embodiment, a gap is provided between the protruding wall section 83a and the first circuit board 61. That is, the lower end of the protruding wall section 83a is located above and away from the upper surface of the first circuit board 61. The lower end of the protruding wall section 83a is located below the first extending sections 71c. In the present embodiment, a gap is provided between the protruding wall section 83b and the second circuit board 62. That is, the lower end of the protruding wall section 83b is located above and away from the upper surface of the second circuit board 62. The lower end of the protruding wall section 83b is located below the first extending sections 72c. The protruding wall section 83a is located above the signal lines 61d. The protruding wall section 83b is located above the signal lines 62d.

The shortest distance in the second horizontal direction Y between the protruding wall section 83a and the first housing 71a is, for example, smaller than the dimension of the first housing 71a in the second horizontal direction Y. The shortest distance in the second horizontal direction Y between the protruding wall section 83a and the first housing 71a is greater than the shortest distance in the upward-downward direction Z between the facing wall section 81 and the connector unit 70. The shortest distance in the second horizontal direction Y between the protruding wall section 83a and the first housing 71a is, for example, greater than or equal to about 0.5 mm but smaller than or equal to about 20 mm. The shortest distance in the second horizontal direction Y between the protruding wall section 83a and the first housing 71a is preferably, for example, smaller than 10 mm. The shortest distance in the second horizontal direction Y between the protruding wall section 83b and the second housing 72a is similar to the shortest distance in the second horizontal direction Y between the protruding wall section 83a and the first housing 71a. The shortest distance in the second horizontal direction Y between the protruding wall section 83b and the second housing 72a is, for example, smaller than the dimension of the second housing 72a in the second horizontal direction Y.

The dimension of the gap between the protruding wall section 83a and the first circuit board 61 in the upward-downward direction Z is smaller than the plate thickness of the first circuit board 61, that is, the dimension of the first circuit board 61 in the upward-downward direction Z. The dimension of the gap between the protruding wall section 83a and the first circuit board 61 in the upward-downward direction Z is, for example, greater than or equal to about 0.5 mm but smaller than or equal to about 20 mm. The dimension of the gap between the protruding wall section 83a and the first circuit board 61 in the upward-downward direction Z is preferably, for example, smaller than 10 mm. The dimension of the gap between the protruding wall section 83b and the second circuit board 62 in the upward-downward direction Z is similar to the dimension of the gap between the protruding wall section 83a and the first circuit board 61 in the upward-downward direction Z. The dimension of the gap between the protruding wall section 83b and the second circuit board 62 in the upward-downward direction Z is smaller than the plate thickness of the second circuit board 62, that is, the dimension of the second circuit board 62 in the upward-downward direction Z.

The coupling wall sections 84 protrude downward from the facing wall section 81, as shown in FIG. 2. In the present embodiment, the coupling wall sections 84 each have the shape of a plate having plate surfaces facing the opposite sides in the first horizontal direction X. The plate surfaces of each of the coupling wall sections 84 are perpendicular to the first horizontal direction X. In the present embodiment, the coupling wall sections 84 each have the shape of a substantially rectangular plate elongated in the second horizontal direction Y. The dimension of each of the coupling wall sections 84 in the second horizontal direction Y is smaller than the dimension of the facing wall section 81 in the second horizontal direction Y. In the present embodiment, the coupling wall sections 84 are portions bent in the upward-downward direction Z from at the edge portions of the facing wall section 81 that face the opposite sides in the first horizontal direction X.

In the present embodiment, the coupling wall sections 84 are configured with a pair of coupling wall section 84a (first coupling wall section) and a coupling wall section 84b (second coupling wall section). The coupling wall section 84a protrudes downward from the edge portion of the facing wall section 81 at the one side in the first horizontal direction, that is, the +X side. The coupling wall section 84b protrudes downward from the edge portion of the facing wall section 81 at the other side in the first horizontal direction, that is, the -X side. The coupling wall section 84a links the fixing section 82a and the facing wall section 81 to each other. The coupling wall section 84b links the fixing section 82b and the facing wall section 81 to each other. That is, the coupling wall section 84b is disposed at the side opposite the coupling wall section 84a and is linked to the facing wall section 81.

The pair of coupling wall sections 84a and 84b are provided to sandwich the connector unit 70 in the first horizontal direction X. The pair of coupling wall sections 84a and 84b face the connector unit 70 in the first horizontal direction X. The coupling wall section 84a is located away from the first connector 71 and the second connector 72 toward the one side in the first horizontal direction, that is, the +X side, and faces the first connector 71 and the second connector 72 with a gap therebetween. The coupling wall section 84a covers at least a part of the first connector 71 and at least a part of the second connector 72 from the one side in the first horizontal direction. In the present embodiment, the coupling wall section 84a covers the entire first connector 71 and the entire second connector 72 from the one side in the first horizontal direction. The coupling wall section 84b is located away from the first connector 71 and the second connector 72 toward the other side in the first horizontal direction, that is, the -X side, and faces the first connector 71 and the second connector 72 with a gap therebetween. The coupling wall section 84b covers at least a part of the first connector 71 and at least a part of the second connector 72 from the other side in the first horizontal direction. In the present embodiment, the coupling wall section 84b covers the entire first connector 71 and the entire second connector 72 from the other side in the first horizontal direction.

The coupling wall section 84a is located away from the protruding wall sections 83a and 83b toward the one side in the first horizontal direction, that is, the +X side. Gaps that cause the interior of the cover section 80a and the exterior of the cover section 80a to communicate with each other are provided between the coupling wall section 84a and the protruding wall sections 83a and 83b. The coupling wall section 84b is located away from the protruding wall sections 83a and 83b toward the other side in the first horizontal direction, that is, the -X side. Gaps that cause the interior of the cover section 80a and the exterior of the cover section 80a to communicate with each other are provided between the coupling wall section 84b and the protruding wall sections 83a and 83b. The pair of coupling wall sections 84a and 84b each extend in the second horizontal direction Y from the upper side of the first circuit board 61 to the upper side of the second circuit board 62.

The bent sections 83c and 83d are portions bent in the second horizontal direction Y at edge portions of the protruding wall sections 83 that face the opposite sides in the first horizontal direction X. The bent sections 83c are bent at the edge portions of the protruding wall section 83a that face the opposite sides in the first horizontal direction X toward the one side in the second horizontal direction, that is, the +Y side. In the present embodiment, the bent sections 83c are provided at opposite edge portions of the protruding wall section 83a that face the opposite sides in the first horizontal direction X. The bent section 83c located at the one side in the first horizontal direction, that is, the +X side is inserted into the gap between the protruding wall section 83a and the coupling wall section 84a. The bent section 83c located at the other side in the first horizontal direction, that is, the -X side is inserted into the gap between the protruding wall section 83a and the coupling wall section 84b. At least a part of each of the bent sections 83c is located between the corresponding one of the coupling wall sections 84a and 84b and the connector unit 70 in the first horizontal direction X. In the present embodiment, a portion of each of the bent sections 83c at the one side in the second horizontal direction is located between the corresponding one of the coupling wall sections 84a and 84b and the first connector 71 in the first horizontal direction X. The bent sections 83c may be in contact with the coupling wall sections 84a and 84b, or may be disposed so as to be separate from the coupling wall sections 84a and 84b.

The bent sections 83d are bent at the edge portions of the protruding wall section 83b that face the opposite sides in the first horizontal direction X toward the other side in the second horizontal direction, that is, the -Y side, as shown in FIG. 6. In the present embodiment, the bent sections 83d are provided at opposite edge portions of the protruding wall section 83b that face the opposite sides in the first horizontal direction X. The pair of bent sections 83d are so disposed that the pair of bent sections 83d and the pair of bent sections 83c are symmetrical along the second horizontal direction Y. The pair of bent sections 83c and the pair of bent sections 83d are disposed so as to be separate from and face each other in the second horizontal direction Y. In the present embodiment, a portion of each of the bent sections 83d at the other side in the second horizontal direction is located between the corresponding one of the coupling wall sections 84a and 84b and the second connector 72 in the first horizontal direction X.

The fixing sections 82a and 82b are portions fixed to the first circuit board 61 and the second circuit board 62, as shown in FIG. 2. The fixing section 82a protrudes from the lower edge of the coupling wall section 84a toward the one side in the first horizontal direction, that is, the +X side. In the present embodiment, the fixing section 82a includes a plate-shaped section 85, a pair of tubular sections 82e and 82f, and a pair of engaging tabs 82g and 82h.

The plate-shaped section 85 is a plate-shaped portion linked to the coupling wall section 84a. The plate surfaces of the plate-shaped section 85 are perpendicular to the upward-downward direction Z. In the present embodiment, the plate-shaped section 85 has the shape of a substantially rectangular plate elongated in the second horizontal direction Y. The lower end of the coupling wall section 84a is linked to the edge of the plate-shaped section 85 at the other side in the first horizontal direction, that is, the -X side. In the present embodiment, the plate-shaped section 85 is a portion bent in the first horizontal direction X at the lower edge of the coupling wall section 84a. The lower surface of the plate-shaped section 85 is in contact with the first ground pad 61i formed at the upper surface of the first circuit board 61 and the second ground pad 62i formed at the upper surface of the second circuit board 62. The plate-shaped section 85 is thus electrically coupled to the first ground layer 61g and the second ground layer 62g via the first ground pad 61i and the second ground pad 62i.

The portion of the plate-shaped section 85 that is electrically coupled to the first ground pad 61i is a first coupling section 85a, which is electrically coupled to the first ground layer 61g via the first ground pad 61i. The portion of the plate-shaped section 85 that is electrically coupled to the second ground pad 62i is a second coupling section 85b, which is electrically coupled to the second ground layer 62g via the second ground pad 62i. In the present embodiment, the first coupling section 85a is a portion of the plate-shaped section 85 at the other side in the second horizontal direction, that is, the -Y side. The second coupling section 85b is a portion of the plate-shaped section 85 at the one side in the second horizontal direction, that is, the +Y side. In the present embodiment, the first coupling section 85a and the second coupling section 85b are linked to each other. The first coupling section 85a and the second coupling section 85b are linked to the coupling wall section 84a. That is, in the present embodiment, the coupling wall section 84a links both the first coupling section 85a and the second coupling section 85b to the facing wall section 81.

The pair of tubular sections 82e and 82f protrude upward from the plate-shaped section 85. The pair of tubular sections 82e and 82f each have a tubular shape that opens upward. The pair of tubular sections 82e and 82f are provided with a gap therebetween in the second horizontal direction Y. The tubular section 82e is provided at the first coupling section 85a. The tubular portion 82f is provided at the second coupling section 85b.

The pair of engaging tabs 82g and 82h protrude downward from opposite edges of the plate-shaped section 85 that face the opposite sides in the second horizontal direction Y. The engaging tab 82g protrudes downward from the edge of the plate-shaped section 85 at the other side in the second horizontal direction, that is, the -Y side. The engaging tab 82h protrudes downward from the edge of the plate-shaped section 85 at the one side in the second horizontal direction, that is, the +Y side. The engaging tab 82g is inserted from above into an engaging hole 61k formed in the first circuit board 61, as shown in FIG. 5. The engaging hole 61k passes through the first circuit board 61 in the upward-downward direction Z. The engaging tab 82h is inserted from above into an engaging hole 62k formed in the second circuit board 62. The engaging hole 62k passes through the second circuit board 62 in the upward-downward direction Z.

A pair of female threaded holes 82i and 82j are formed in the fixing section 82a. The female threaded hole 82i is formed in the first coupling section 85a and passes through the first coupling section 85a and the tubular section 82e in the upward-downward direction Z. The inner circumferential surface of the tubular section 82e constitutes a part of the inner circumferential surface of the female threaded hole 82i. A female threaded portion is formed at the inner circumferential surface of the female threaded hole 82i. The female threaded hole 82j is formed in the second coupling section 85b and passes through the second coupling section 85b and the tubular section 82f in the upward-downward direction Z. The inner circumferential surface of the tubular section 82f constitutes a part of the inner circumferential surface of the female threaded hole 82j. A female threaded portion is formed at the inner circumferential surface of the female threaded hole 82j.

A bolt 91, which is made of metal and fixes the first coupling section 85a to the first circuit board 61, is screwed into the female threaded hole 82i. The bolt 91 is caused to passes from below through a through hole 61h formed in the first circuit board 61 and is screwed into the female threaded hole 82i. The through hole 61h passes through the first circuit board 61 in the upward-downward direction Z. The inner diameter of the through hole 61h is greater than the inner diameter of the female threaded hole 82i. The upper end of the through hole 61h opens to the first ground pad 61i. An upper end portion of the bolt 91 protrudes above the tubular section 82e. Since the first coupling section 85a is fixed to the first circuit board 61 with the bolt 91, the lower surface of the first coupling section 85a is preferably pressed against the first ground pad 61i. Therefore, the first coupling section 85a is preferably electrically coupled to the first ground pad 61i, and the first coupling section 85a is preferably electrically coupled to the first ground layer 61g.

A bolt 92, which is made of metal and fixes the second coupling section 85b to the second circuit board 62, is screwed into the female threaded hole 82j. The bolt 92 is caused to pass from below through a through hole 62h formed in the second circuit board 62 and is screwed into the female threaded hole 82j. The through hole 62h passes through the second circuit board 62 in the upward-downward direction Z. The inner diameter of the through hole 62h is greater than the inner diameter of the female threaded hole 82j. The upper end of the through hole 62h opens to the second ground pad 62i. An upper end portion of the bolt 92 protrudes above the tubular section 82f. Since the second coupling section 85b is fixed to the second circuit board 62 with the bolt 92, the lower surface of the second coupling section 85b is preferably pressed against the second ground pad 62i. Therefore, the second coupling section 85b is preferably electrically coupled to the second ground pad 62i, and the second coupling section 85b is preferably electrically coupled to the second ground layer 62g.

The fixing section 82b is so disposed that the fixing section 82b and the fixing section 82a are symmetrical along the first horizontal direction X, as shown in FIG. 2. The fixing section 82b includes a first coupling section electrically coupled to the first ground layer 61g and a second coupling section electrically coupled to the second ground layer 62g, as the fixing section 82a. The first coupling section 85a of the fixing section 82b is electrically coupled to the first ground layer 61g via the first ground pad 61j. The second coupling section 85b of the fixing section 82b is electrically coupled to the second ground layer 62g via the second ground pad 62j.

A current Is1 flows and a signal is therefore transmitted between the first circuit board 61 and the second circuit board 62 via the connector unit 70. In the example shown in FIG. 4, the current Is1 flowing from the first circuit board 61 to the second circuit board 62 is indicated with the broken-line arrows. The current Is1 flows from the signal lines 61d formed in the first circuit board 61 to the signal lines 62d formed in the second circuit board 62 through the first couplers 71b and the second couplers 72b in this order. When the current Is1 flows as described above, a return current Ir1 corresponding to the current Is1 flows.

The return current Ir1 indicated by the broken-line arrows in the example shown in FIG. 4 is a return current flowing from the second ground layer 62g of the second circuit board 62 to the first ground layer 61g of the first circuit board 61. The return current Ir1 flows through the portion of the second ground layer 62g that is located below the signal lines 62d in the opposite direction of the direction of the current Is1, and then flows from the second ground layer 62g to the protruding wall section 83b. In the present embodiment, although the second ground layer 62g and the protruding wall section 83b are not coupled to each other via a conductor, the return current Ir1 generated in response to the current Is1, which is a high-frequency current, can propagate from the second ground layer 62g to the protruding wall section 83b with the aid of spatial capacitive coupling. The return current Ir1 having flowed into the protruding wall section 83b flows through the facing wall section 81 and the protruding wall section 83a in this order, and flows from the protruding wall section 83a into the first ground layer 61g of the first circuit board 61. In the present embodiment, although the protruding wall section 83a and the first ground layer 61g are not also coupled to each other via a conductor, the return current Ir1 generated in response to the high-frequency current Is1 can propagate from the protruding wall section 83a into the first ground layer 61g with the aid of spatial capacitive coupling. The return current Ir1 having flowed into the first ground layer 61g flows through the portion of the first ground layer 61g that is located below the signal lines 61d in the opposite direction of the direction of the current Is1.

As described above, in the present embodiment, a return path along which the return current Ir1 generated when the current Is1 flows through the connector unit 70 flows is formed by the metal member 80. Note that when the current Is1 flows from the second circuit board 62 to the first circuit board 61, the return current Ir1 flows in the opposite direction of the direction indicated with the broken-line arrows shown in FIG. 4, and flows from the first ground layer 61g to the second ground layer 62g.

According to the present embodiment, the circuit board unit 60 includes the first circuit board 61 including the first ground layer 61g, the second circuit board 62 including the second ground layer 62g, the connector unit 70 including the first connector 71 attached to the first circuit board 61 and the second connector 72 attached to the second circuit board 62, and the metal member 80, which couples the first circuit board 61 and the second circuit board 62 to each other. The metal member 80 includes the first coupling section 85a electrically coupled to the first ground layer 61g, the second coupling section 85b electrically coupled to the second ground layer 62g, and the cover section 80a, which covers at least a part of the connector unit 70. The cover section 80a includes the facing wall section 81, which at least partially faces the connector unit 70 in the upward-downward direction Z perpendicular to the plate surfaces of the first circuit board 61. The facing wall section 81 overlaps with the first circuit board 61 when viewed in the upward-downward direction Z perpendicular to the plate surfaces of the first circuit board 61, and overlaps with the second circuit board 62 when viewed in the upward-downward direction Z perpendicular to the plate surfaces of the second circuit board 62.

The return current Ir1 is therefore readily allowed to propagate between the first ground layer 61g of the first circuit board 61 and the facing wall section 81 and between the second ground layer 62g of the second circuit board 62 and the facing wall section 81 with the facing wall section 81 disposed in the vicinity of the connector unit 70. The metal member 80 can thus preferably provide the return path along which the return current Ir1 flows between the first circuit board 61 and the second circuit board 62, as described above. The electromagnetic field generated by the return current Ir1 flowing through the metal member 80 can therefore preferably cancel the electromagnetic field generated by the current Is1 flowing through the connector unit 70. Unwanted radiation noise caused by the current Is1 flowing through the connector unit 70, which links the first circuit board 61 and the second circuit board 62 to each other, can therefore be preferably suppressed. In other words, since the energy of the current Is1 flowing through the connector unit 70 and the energy of the return current Ir1 are balanced, and excessive energy is therefore unlikely to be generated, so that unwanted radiation noise caused by the otherwise excessive energy can be preferably suppressed.

Since the metal member 80 includes the first coupling section 85a and the second coupling section 85b, the first ground layer 61g of the first circuit board 61 and the second ground layer 62g of the second circuit board 62 can be electrically coupled to each other via the metal member 80. The potential at each of the ground layers can therefore be more preferably stabilized. The unwanted radiation noise caused by the current Is1 flowing through the signal lines 61d and 62d and the like along the ground layers can therefore be more preferably suppressed.

The metal member 80 can provide the connector unit 70 with a return current path, such as the first ground layer 61g and the second ground layer 62g. Therefore, even when the couplers of the connector unit 70 are separate from the circuit boards, the metal member 80 can provide the couplers separate from the circuit boards with a path of the return current Ir1. The path of the return current Ir1 for the couplers and the wiring layers provided in the circuit boards can therefore be shortened, as compared with a case where the metal member 80 is not provided. The path of the return current Ir1 for the couplers can therefore be readily designed, so that deterioration of the quality of the signals flowing to the couplers can be suppressed.

Covering at least a part of the connector unit 70 with the cover section 80a of the metal member 80 allows the cover section 80a to block at least part of electromagnetic waves generated from the connector unit 70. The configuration described above can therefore suppress leakage of the electromagnetic waves generated from the connector unit 70 to the exterior of the circuit board unit 60.

According to the present embodiment, the cover section 80a includes the protruding wall section 83 that protrudes from the facing wall section 81 toward one of the first circuit board 61 and the second circuit board 62. The protruding wall sections 83 face the connector unit 70 in the second horizontal direction Y perpendicular to the upward-downward direction Z perpendicular to the plate surfaces of the first circuit board 61. The protruding wall sections 83 are each therefore allowed to be close to the first ground layer 61g of the first circuit board 61 or the second ground layer 62g of the second circuit board 62. The return current Ir1 is thus allowed to readily propagate between the first ground layer 61g or the second ground layer 62g and the metal member 80. The return current Ir1 is therefore allowed to more preferably flow to the metal member 80, so that the unwanted radiation noise caused by the current Is1 flowing through the connector unit 70 can be more preferably suppressed. Furthermore, since the connector unit 70 can be covered in the second horizontal direction Y with the protruding wall sections 83, part of the electromagnetic waves generated from the connector unit 70 can be blocked by the protruding wall sections 83. The configuration described above can suppress leakage of the electromagnetic waves generated from the connector unit 70 to the exterior of the circuit board unit 60 by a greater degree.

According to the present embodiment, the cover section 80a further includes the protruding wall section 83 that protrudes from the facing wall section 81 toward the other of the first circuit board 61 and the second circuit board 62. In the present embodiment, the protruding wall section 83 that protrudes toward the first circuit board 61 is the protruding wall section 83a as the first protruding wall section, and the protruding wall section 83 that protrudes toward the second circuit board 62 is the protruding wall section 83b as the second protruding wall section. The protruding wall sections 83a and 83b sandwich the connector unit 70 in the second horizontal direction Y. The protruding wall section 83a as the first protruding wall section protrudes from the facing wall section 81 toward the first circuit board 61. The protruding wall section 83b as the second protruding wall section protrudes from the facing wall section 81 toward the second circuit board 62. Therefore, the protruding wall section 83a can be disposed so as to be close to the first ground layer 61g, and the protruding wall section 83b can be disposed so as to be close to the second ground layer 62g. The return current Ir1 is therefore allowed to readily propagate both between the first ground layer 61g and the metal member 80 and between the second ground layer 62g and the metal member 80. The return current Ir1 is therefore allowed to more preferably flow to the metal member 80, so that the unwanted radiation noise caused by the current Is1 flowing through the connector unit 70 can be more preferably suppressed.

According to the present embodiment, a gap is provided between the protruding wall sections 83 and the circuit boards. The signal lines 61d and 62d coupled to the connector unit 70 can therefore be formed in portions of the upper surfaces of the circuit boards, the portions facing the protruding wall sections 83. Complication of the wiring patterns formed at each of the circuit boards can thus be suppressed.

According to the present embodiment, the cover section 80a includes the coupling wall sections 84, which link at least one of the first coupling section 85a and the second coupling section 85b to the facing wall section 81. The coupling wall sections 84 face the connector unit 70 in the first horizontal direction X perpendicular to both the upward-downward direction Z and the second horizontal direction Y. The coupling wall sections 84 can therefore link at least one of the first coupling section 85a and the second coupling section 85b to the facing wall section 81 to support the facing wall section 81. The facing wall section 81 can therefore be preferably disposed at a position where the facing wall section 81 faces the connector unit 70 in the upward-downward direction Z. Furthermore, since the connector unit 70 can be covered in the first horizontal direction X with the coupling wall sections 84, part of the electromagnetic waves generated from the connector unit 70 can be blocked by the coupling wall sections 84. The configuration described above can suppress leakage of the electromagnetic waves generated from the connector unit 70 to the exterior of the circuit board unit 60 by a greater degree.

According to the present embodiment, the cover section 80a includes the coupling wall section 84a as the first coupling wall section, and the coupling wall section 84b as the second coupling wall section disposed at the side opposite the coupling wall section 84a as the first connection wall section and linked to the facing wall section 81. The coupling wall sections 84a and 84b are provided to sandwich the connector unit 70 in the first horizontal direction X. The facing wall portion 81 can therefore be supported by the coupling wall sections 84a and 84b. The facing wall section 81 can therefore be more stably disposed with respect to the connector unit 70. Furthermore, since a situation in which the facing wall section 81 is supported in the form of a cantilever in the first horizontal direction X can be avoided, a situation in which an end portion of the facing wall section 81 in the first horizontal direction X electrically vibrates can be avoided. A situation in which the facing wall section 81 serves as an antenna that radiates the unwanted radiation noise can thus be avoided.

According to the present embodiment, the pair of fixing sections 82a and 82b coupled to the pair of coupling wall sections 84a and 84b respectively are provided, and the fixing sections 82a and 82b are each provided with the first coupling section 85a and the second coupling section 85b. The first ground layer 61g and the second ground layer 62g can therefore be more preferably electrically coupled to each other by the pair of first coupling sections 85a and the pair of second coupling sections 85b. The potential at each of the ground layers can therefore be more preferably stabilized. The unwanted radiation noise caused by the current Is1 flowing through the signal lines 61d and 62d and the like along the ground layers can therefore be more preferably suppressed.

According to the present embodiment, the metal member 80 is a sheet metal member. The protruding wall sections 83 are portions bent in the upward-downward direction Z at the edge portions of the facing wall section 81 that face the opposite sides in the second horizontal direction Y. The coupling wall sections 84 are portions bent in the upward-downward direction Z at the edge portions of the facing wall section 81 that face the opposite sides in the first horizontal direction X. Creating the protruding wall sections 83 and the coupling wall sections 84 by bending the facing wall section 81 as described above readily allows individual adjustment of the dimension of the protruding wall sections 83 in the upward-downward direction Z and the dimension of the coupling wall sections 84 in the upward-downward direction Z. The cover section 80a can therefore be readily created in accordance, for example, with the dimension of the connector unit 70 in the upward-downward direction Z.

According to the present embodiment, the cover section 80a includes the bent sections 83c and 83d, which are bent in the second horizontal direction Y at the edges of the protruding wall sections 83 that face the opposite sides in the first horizontal direction X. At least portions of the bent sections 83c and 83d are disposed between the coupling wall sections 84 and the connector unit 70 in the first horizontal direction X. At least portions of the gaps between the protruding wall sections 83 and the coupling wall sections 84, which are created when the protruding wall sections 83 and the coupling wall sections 84 are created by bending the facing wall section 81, can therefore be closed by the bent sections 83c and 83d. The connector unit 70 can thus be more preferably covered with the cover section 80a, so that leakage of the electromagnetic waves generated from the connector unit 70 to the exterior of the circuit board unit 60 can be further suppressed.

According to the present embodiment, the plate surfaces of the first circuit board 61 and the plate surfaces of the second circuit board 62 are parallel to each other. The first circuit board 61 and the second circuit board 62 are arranged side by side in the second horizontal direction Y along the plate surfaces of the first circuit board 61 and the plate surfaces of the second circuit board 62. The connector unit 70, which couples the first circuit board 61 and the second circuit board 62 to each other, is therefore preferably readily covered with the cover section 80a with the metal member 80 having a relatively simple structure.

According to the present embodiment, each of the first coupling sections 85a and the corresponding one of second coupling section 85b are linked to each other. Complication of the structure of the metal member 80 can therefore be suppressed as compared with a case where the first coupling sections 85a and the second coupling sections 85b are separately provided. Furthermore, the first ground layer 61g and the second ground layer 62g can be electrically coupled to each other via the first coupling sections 85a and the second coupling sections 85b linked to each other. The first ground layer 61g and the second ground layer 62g are therefore more preferably readily electrically coupled to each other.

According to the present embodiment, the first couplers 71b of the first connector 71 protrude from the first housing 71a, which holds the first couplers 71b. The facing wall section 81 faces the first couplers 71b and the first housing 71a in the upward-downward direction Z perpendicular to the plate surfaces of the first circuit board 61. The end of the facing wall section 81 at the side where the first couplers 71b protrude from the first housing 71a is located outside the ends of the first couplers 71b at the side where the first couplers 71b protrude from the first housing 71a. The first connector 71 is therefore preferably readily covered from above with the facing wall portion 81. Furthermore, when the protruding wall section 83a, which protrudes downward, is provided at the end of the facing wall section 81 at the side where the first couplers 71b protrude from the first housing 71a, the protruding wall section 83a can be disposed at a position where the protruding wall section 83a does not overlap with the first couplers 71b in the upward-downward direction Z. The lower end of the protruding wall section 83a is therefore allowed to be close to the first circuit board 61 while a situation in which the lower end of the protruding wall section 83a comes into contact with the first couplers 71b is avoided. The return current Ir1 is therefore allowed to readily flow between the protruding wall section 83a and the first ground layer 61g. The same holds true for the relationship between the second couplers 72b of the second connector 72 and the facing wall section 81.

Embodiments different from the embodiment described above will be described below. In the following description of each embodiment below, the same configurations as those described earlier than the description of the embodiment below have the same reference characters as appropriate, and will not be described in some cases. In addition, portions corresponding to the sections having the configurations described earlier than the description of each embodiment below have same names but have different reference characters, and points different from those of the configurations described above will be described, but the same points as those of the configurations described above will not be described in some cases. Note in each of the following embodiments that a configuration that is not described can employ the same configuration as that described earlier than the embodiment to the extent that no contradiction occurs.

### Second embodiment

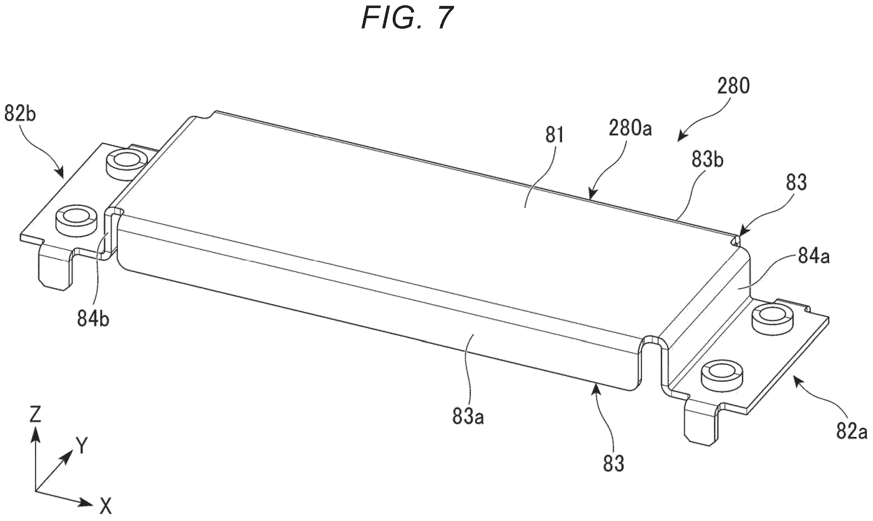

The present embodiment differs from the first embodiment in that a metal member 280 is shaped differently. FIG. 7 is a cross-sectional view showing the metal member 280 in the present embodiment. Unlike the cover section 80a in the first embodiment, a cover section 280a of the metal member 280 has neither the bent section 83c nor 83d, as shown in FIG. 7. It is therefore not necessary to carry out the bending for creating the bent sections 83c and 83d. The metal member 280 can therefore be readily created. Other configurations of the cover section 280a are the same as those of the cover section 80a in the first embodiment. The other configurations of the metal member 280 are the same as those of the metal member 80 in the first embodiment.

### Third embodiment

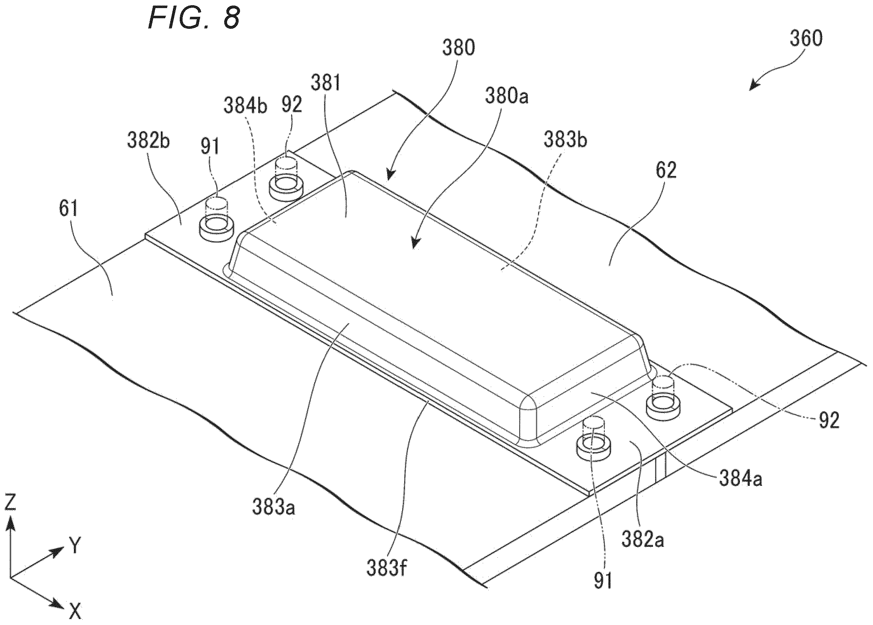

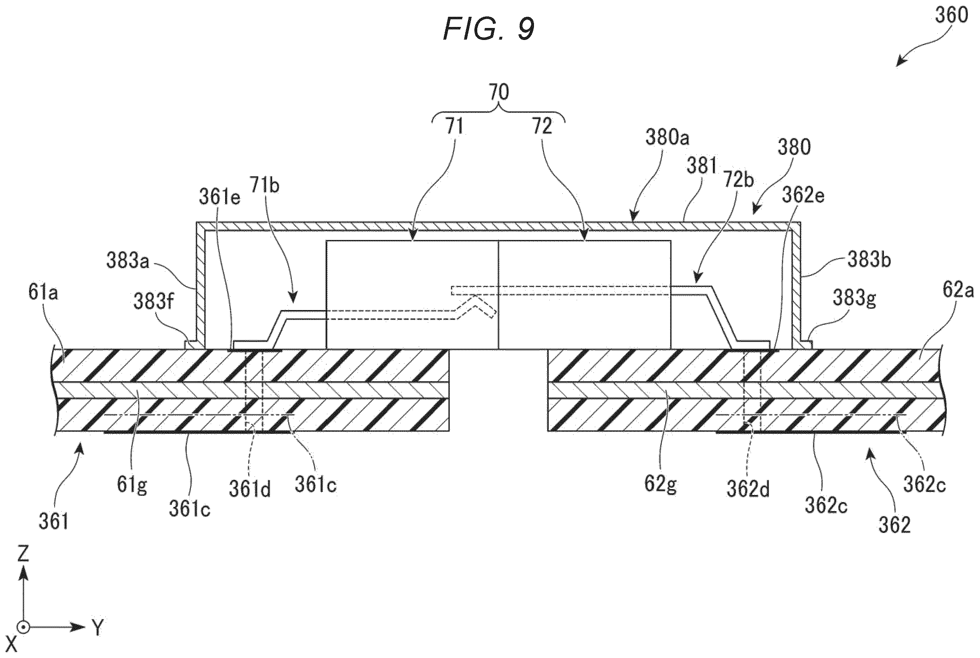

The present embodiment differs from the first embodiment in that a metal member 380 is shaped differently. FIG. 8 is a perspective view showing a part of a circuit board unit 360 according to the present embodiment. FIG. 9 is a cross-sectional view showing a part of the circuit board unit 360 according to the present embodiment. A cover section 380a of the metal member 380 is so configured that a pair of protruding wall sections 383a and 383b and a pair of coupling wall sections 384a and 384b are linked to each other in the direction surrounding the connector unit 70, and constitute a rectangular-frame-shaped wall portion that surrounds the connector unit 70 around an axis extending in the upward-downward direction Z, as shown in FIGS. 8 and 9. In the present embodiment, the cover section 380a is created by drawing a sheet metal. The upper end of the rectangular-frame-shaped wall portion configured with the pair of protruding wall sections 383a and 383b and the pair of coupling wall sections 384a and 384b is linked to the entire outer circumferential edge of a facing wall section 381.

The protruding wall section 383a (first protruding wall section) is in contact with a first circuit board 361, as shown in FIG. 9. In more detail, the lower end of the protruding wall section 383a is in contact with the upper surface of the first circuit board 361. A protruding edge section 383f, which protrudes toward the other side in the second horizontal direction, that is, the -Y side is formed at the lower end of the protruding wall section 383a. The protruding edge section 383f is in contact with the upper surface of the first circuit board 361. The protruding edge section 383f extends in the first horizontal direction X and links a fixing section 382a and a fixing section 382b to each other, as shown in FIG. 8. The fixing sections 382a and 382b are the same as the fixing sections 82a and 82b in the first embodiment except that neither the engaging tab 82g nor 82h are provided.

The protruding wall section 383b (second protruding wall section) is in contact with a second circuit board 362, as shown in FIG. 9. In more detail, the lower end of the protruding wall section 383b is in contact with the upper surface of the second circuit board 362. A protruding edge section 383g, which protrudes toward the one side in the second horizontal direction, that is, the +Y side is formed at the lower end of the protruding wall section 383b. The protruding edge section 383g is in contact with the upper surface of the first circuit board 361. The protruding edge section 383g extends in the first horizontal direction X and links the fixing section 382a and the fixing section 382b to each other. Other configurations of the cover section 380a are the same as those of the cover section 80a in the first embodiment. The other configurations of the metal member 380 are the same as those of the metal member 80 in the first embodiment.

Pads 361e, to which the first couplers 71b are electrically coupled, are formed at the upper surface of the first circuit board 361. Signal lines 361c are formed at the lower surface of the first circuit board 361. The pads 361e and the signal lines 361c are electrically coupled to each other via conductive sections 361d. The conductive sections 361d are, for example, vias passing through the first circuit board 361 in the upward-downward direction Z. In the present embodiment, the first couplers 71b are electrically coupled to the signal lines 361c provided at the plate surface opposite the plate surface to which the first couplers 71b are coupled out of the plate surfaces of the first circuit board 361 via the conductive sections 361d formed at the first circuit board 361. The other configurations of the first circuit board 361 are the same as those of the first circuit board 61 in the first embodiment.

Pads 362e, to which the second couplers 72b are electrically coupled, are formed at the upper surface of the second circuit board 362. Signal lines 362c are formed at the lower surface of the second circuit board 362. The pads 362e and the signal lines 362c are electrically coupled to each other via conductive sections 362d. The conductive sections 362d are, for example, vias passing through the second circuit board 362 in the upward-downward direction Z. In the present embodiment, the second couplers 72b are electrically coupled to the signal lines 362c provided at the plate surface opposite the plate surface to which the second couplers 72b are coupled out of the plate surfaces of the second circuit board 362 via the conductive sections 362d formed at the second circuit board 362. The other configurations of the second circuit board 362 are the same as those of the second circuit board 62 in the first embodiment. The other configurations of the circuit board unit 360 are the same as those of the circuit board unit 60 according to the first embodiment.

According to the present embodiment, the protruding wall section 383a is in contact with the first circuit board 361. The protruding wall section 383a can therefore be preferably disposed so as to be close to the first ground layer 61g. The return current Ir1 is therefore allowed to more readily flow between the protruding wall section 383a and the first ground layer 61g. According to the present embodiment, the protruding wall section 383b is in contact with the second circuit board 362. The protruding wall section 383b can therefore be preferably disposed so as to be close to the second ground layer 62g. The return current Ir1 is therefore allowed to more readily flow between the protruding wall section 383b and the second ground layer 62g.

According to the present embodiment, the first couplers 71b are electrically coupled to the signal lines 361c provided at the plate surface opposite the plate surface to which the first couplers 71b are coupled out of the plate surfaces of the first circuit board 361 via the conductive sections 361d formed at the first circuit board 361. Therefore, even when the protruding wall section 383a is brought into contact with the first circuit board 361, the first couplers 71b can be preferably coupled to the signal lines 361c. According to the present embodiment, the second couplers 72b are electrically coupled to the signal lines 362c provided at the plate surface opposite the plate surface to which the second couplers 72b are coupled out of the plate surfaces of the second circuit board 362 via the conductive sections 362d formed at the second circuit board 362. Therefore, even when the protruding wall section 383b is brought into contact with the second circuit board 362, the second couplers 72b can be preferably coupled to the signal lines 362c.

According to the present embodiment, the upper end of the rectangular-frame-shaped wall portion configured with the pair of protruding wall sections 383a and 383b and the pair of coupling wall sections 384a and 384b is linked to the entire outer circumferential edge of a facing wall section 381. Therefore, the connector unit 70 can be surrounded by the rectangular-frame-shaped wall portion throughout the entire circumference around an axis extending in the upward-downward direction Z, and creation of gaps between the facing wall section 381 and the protruding wall section 383a, between the facing wall section 381 and the protruding wall section 383b, between the facing wall section 381 and the coupling wall section 384a (first coupling wall section), and between the facing wall section 381 and the coupling wall section 384b (second coupling wall section). The electromagnetic waves generated from the connector unit 70 can therefore be more preferably blocked by the cover section 380a. The configuration described above can therefore more preferably suppress leakage of the electromagnetic waves generated from the connector unit 70 to the exterior of the circuit board unit 360. In the configuration described above, the cover section 380a including the facing wall section 381, the pair of protruding wall sections 383a and 383b, and the pair of coupling wall sections 384a and 384b can be readily formed by drawing a sheet metal. The metal member 380 can therefore be readily created.

In the present embodiment, the signal lines 361c may be provided in an inner layer of the first circuit board 361, as indicated by the two-dot chain line in FIG. 9. Even in this case, the first couplers 71b can be preferably coupled to the signal lines 361c with the protruding wall section 383a brought into contact with the first circuit board 361. Furthermore, the signal lines 362c may be provided in an inner layer of the second circuit board 362, as indicated by the two-dot chain line in FIG. 9. Even in this case, the second couplers 72b can be preferably coupled to the signal lines 362c with the protruding wall section 383b brought into contact with the second circuit board 362.

### Fourth embodiment

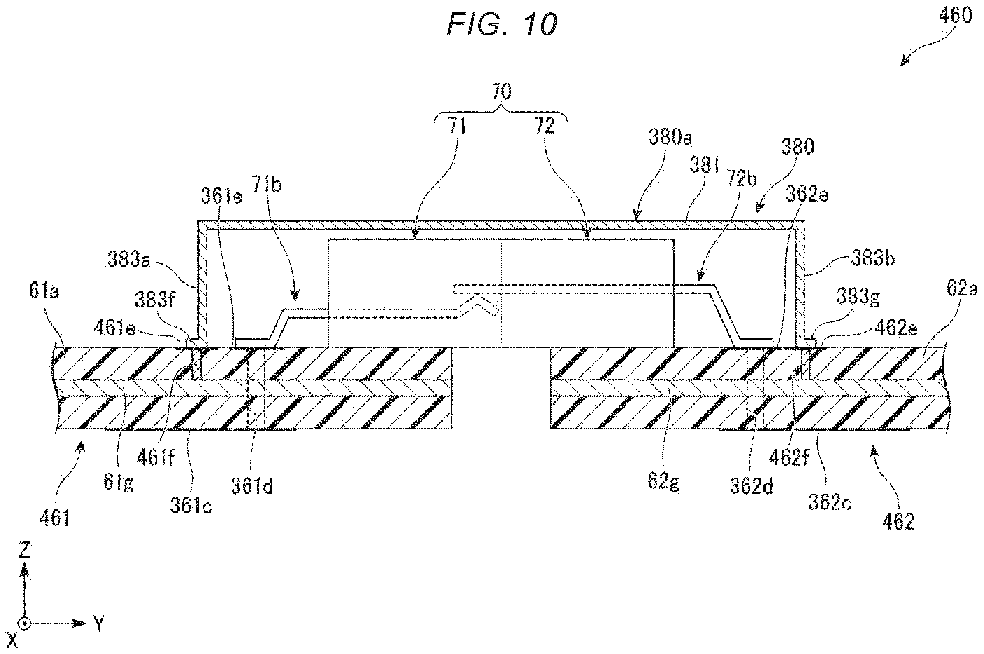

The present embodiment differs from the third embodiment in that the protruding wall sections 383a and 383b of the metal member 380 are electrically coupled to the ground layers. FIG. 10 is a cross-sectional view showing a part of a circuit board unit 460 according to the present embodiment. A ground pad 461e is formed at the upper surface of a first circuit board 461, as shown in FIG. 10. In the present embodiment, the ground pad 461e is provided in the same layer in which the pads 361e are provided, and is electrically coupled to the first ground layer 61g via a via 461f formed in the first insulating layer 61a. Note that the ground pad 461e may be a portion of the first ground layer 61g that is exposed at the upper surface of the first circuit board 461 via an opening formed in the first insulating layer 61a. The lower end of the protruding wall section 383a is in contact with the ground pad 461e. The protruding wall section 383a is therefore electrically coupled to the first ground layer 61g via the ground pad 461e.

A ground pad 462e is formed at the upper surface of a second circuit board 462. In the present embodiment, the ground pad 462e is provided in the same layer in which the pads 362e are provided, and is electrically coupled to the second ground layer 62g via a via 462f formed in the second insulating layer 62a. Note that the ground pad 462e may be a portion of the second ground layer 62g that is exposed at the upper surface of the second circuit board 462 via an opening formed in the second insulating layer 62a. The lower end of the protruding wall section 383b is in contact with the ground pad 462e. The protruding wall section 383b is therefore electrically coupled to the second ground layer 62g via the ground pad 462e.

The other configurations of the first circuit board 461 are the same as those of the first circuit board 361 in the third embodiment. The other configurations of the second circuit board 462 are the same as those of the second circuit board 362 in the third embodiment. The other configurations of the circuit board unit 460 are the same as those of the circuit board unit 360 according to the third embodiment.

According to the present embodiment, the protruding wall section 383a is electrically coupled to the first ground layer 61g via the ground pad 461e formed at the plate surface of the first circuit board 461. The first ground layer 61g and the metal member 380 can therefore be electrically coupled to each other. The return current Ir1 is therefore allowed to more preferably flow between the protruding wall section 383a and the first ground layer 61g. According to the present embodiment, the protruding wall section 383b is electrically coupled to the second ground layer 62g via the ground pad 462e formed at the plate surface of the second circuit board 462. The second ground layer 62g and the metal member 380 can therefore be electrically coupled to each other. The return current Ir1 is therefore allowed to more preferably flow between the protruding wall section 383b and the second ground layer 62g.

### Fifth embodiment

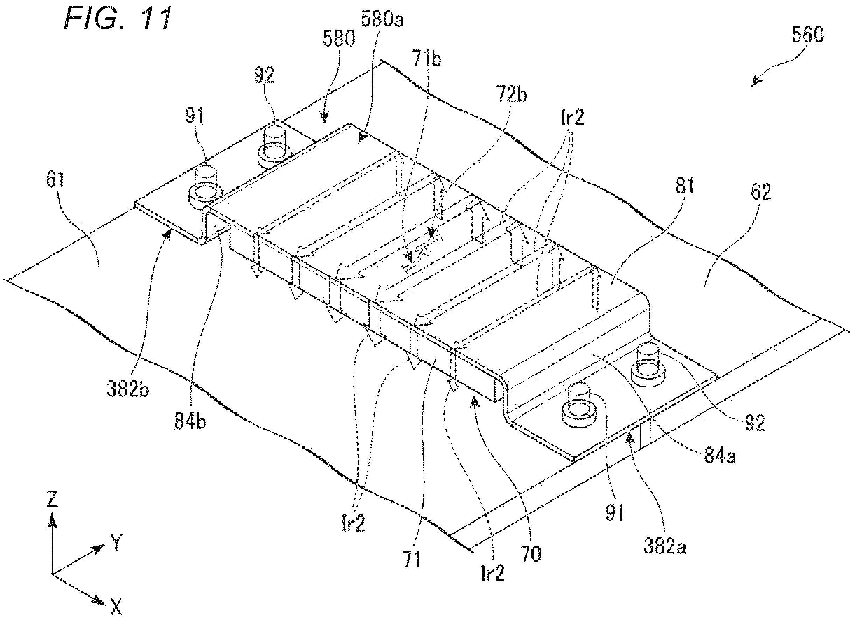

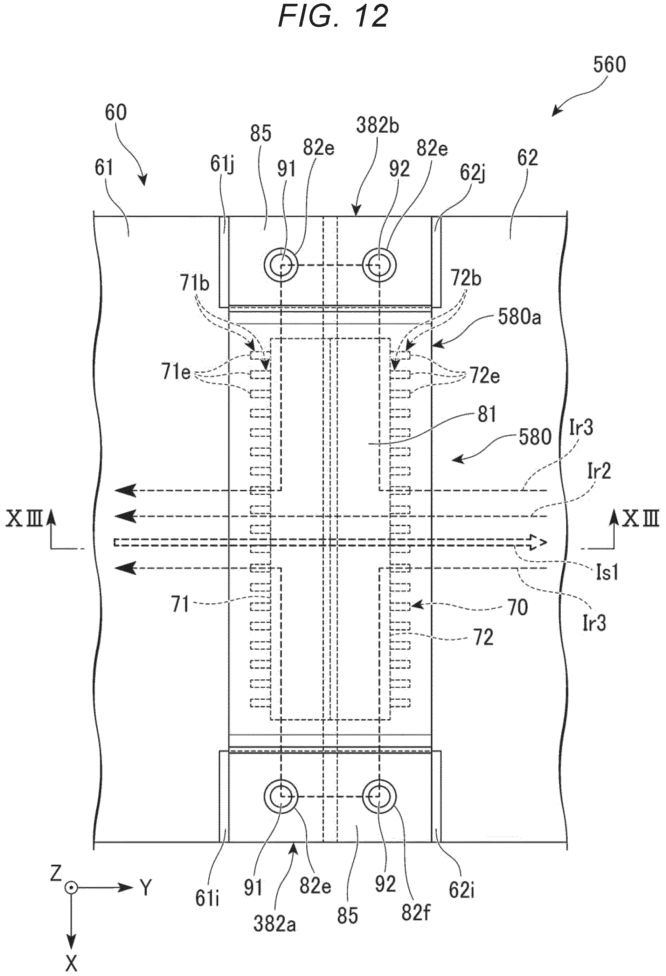

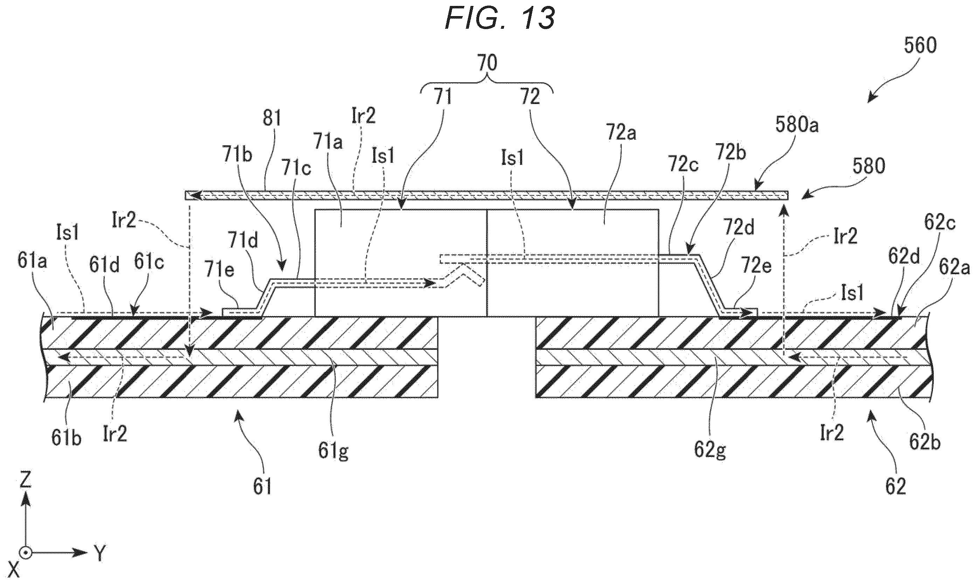

The present embodiment differs from the first embodiment in that a metal member 580 are provided with neither the protruding wall section 83a nor 83b and neither the bent section 83c or 83d. FIG. 11 is a perspective view showing a part of a circuit board unit 560 according to the present embodiment. FIG. 12 is a plan view showing a part of the circuit board unit 560 according to the present embodiment. FIG. 13 is a cross-sectional view showing a part of the circuit board unit 560 according to the present embodiment and taken along the line XIII-XIII in FIG.12.

In the circuit board unit 560 according to the present embodiment, a cover section 580a of the metal member 580 has neither the protruding wall section 83a nor 83b and neither the bent section 83c or 83d, unlike in the first embodiment, as shown in FIGS. 11 to 13. Other configurations of the cover section 580a are the same as those of the cover section 80a in the first embodiment. The metal member 580 includes the fixing sections 382a and 382b, which are the same as those in the third embodiment. The other configurations of the metal member 580 are the same as those of the metal member 80 in the first embodiment. The other configurations of the circuit board unit 560 are the same as those of the circuit board unit 60 according to the first embodiment.

When the current Is1 flows through the connector unit 70 in the present embodiment, return currents Ir2 and Ir3 flowing along paths different from each other are generated, as shown in FIG. 12. Note that FIGS. 11 to 13 show a case where the current Is1 flows from the first circuit board 61 to the second circuit board 62.

The return current Ir2 is a return current flowing through the facing wall section 81, as shown in FIG. 13. In the present embodiment, since neither the protruding wall section 83a nor 83b is provided, the return current Ir2 flowing through the second ground layer 62g directly propagates to the edge of the facing wall section 81 at the one side in the second horizontal direction. In this case, the return current Ir2 flows in the facing wall section 81 in the form of a return current having an electric field distribution. The return current Ir2 flowing in the facing wall section 81 in the form of a return current having an electric field distribution flows from the edge of the facing wall section 81 at the other side in the second horizontal direction to the first ground layer 61g. In FIG. 11, the return current Ir2 generated when the current Is1 flows to the pair of the first couplers 71b and the second couplers 72b is indicated by the broken-line arrows. The closer the return current Ir2 flowing in the form of a return current having an electric field distribution to the first couplers 71b and the second couplers 72b, the greater the return current Ir2, and the farther the return current Ir2 from the first couplers 71b and the second couplers 72b, the smaller the return current Ir2.

The return current Ir3 is a return current flowing through the fixing sections 382a and 382b, as shown in FIG. 12. The return current Ir3 includes the return current Ir3 flowing from the second ground layer 62g of the second circuit board 62 to the first ground layer 61g of the first circuit board 61 via the fixing section 382a, and the return current Ir3 flowing from the second ground layer 62g of the second circuit board 62 to the first ground layer 61g of the first circuit board 61 via the fixing section 382b. The amount of return current Ir3 is greater than the amount of return current Ir2. The return current Ir2 and the return current Ir3 branch off each other at the second ground layer 62g, flow through different portions of the metal member 580, and merge with each other in the first ground layer 61g.

As described above, in the present embodiment as well, the return currents Ir2 and Ir3 corresponding to the current Is1 flowing through the connector unit 70 is allowed preferably to flow through the metal member 580. The unwanted radiation noise caused by the current flowing through the connector unit 70 can therefore be preferably suppressed.

According to the present embodiment, since it is not necessary to provide the metal member 580 with the protruding wall sections 83a and 83b, the structure of the metal member 580 can be further simplified. The metal member 580 can therefore be more readily created.

### Sixth embodiment

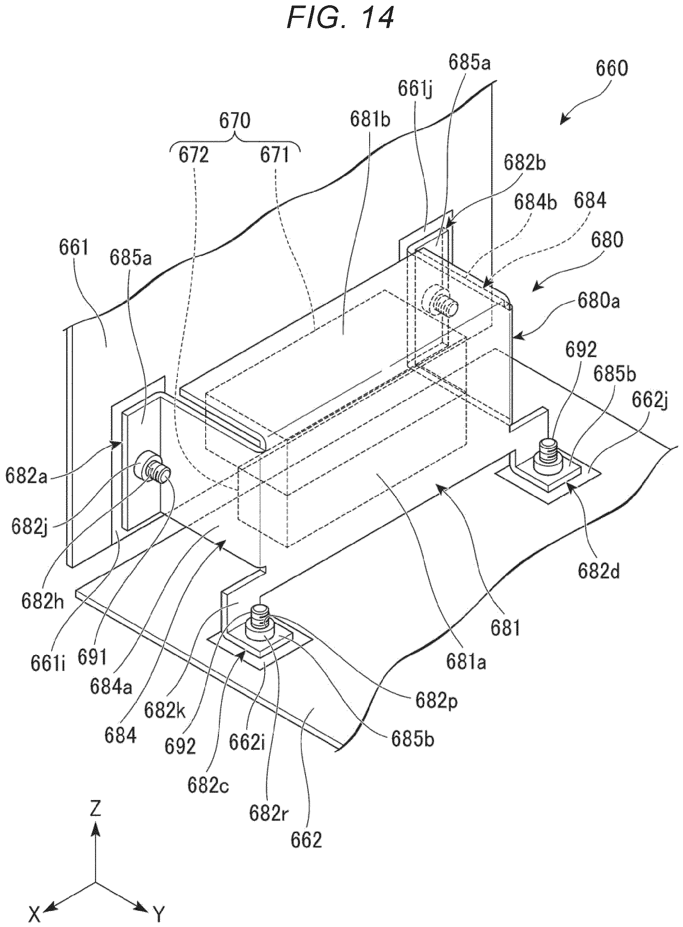

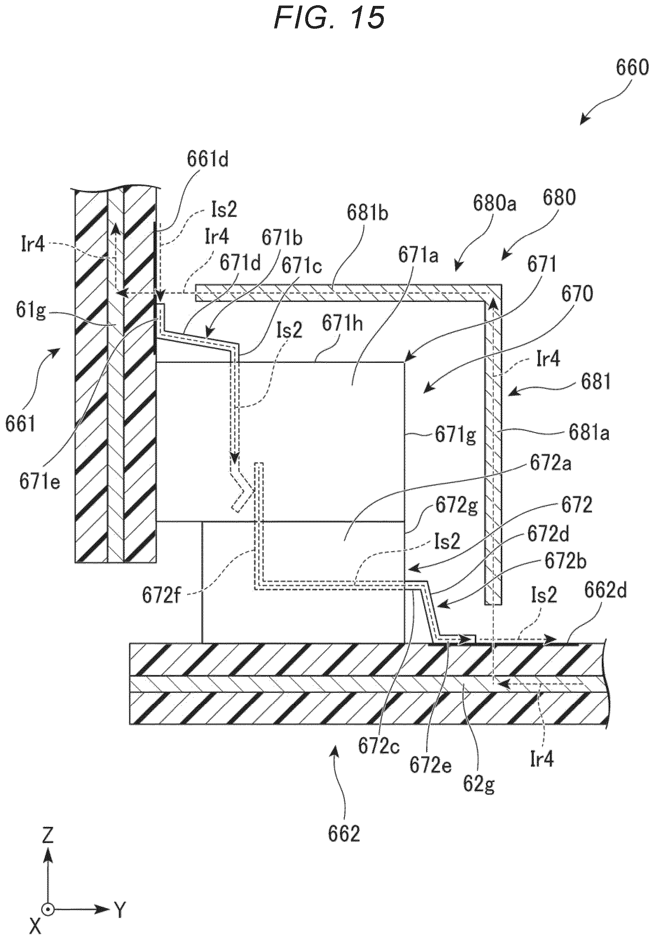

The present embodiment differs from the first embodiment in the arrangement of the first circuit board 661 and the second circuit board 662 relative to each other. FIG. 14 is a perspective view showing a part of a circuit board unit 660 according to the present embodiment. FIG. 15 is a cross-sectional view showing a part of the circuit board unit 660 according to the present embodiment.

In the present embodiment, the plate surfaces of a first circuit board 661 and the plate surfaces of a second circuit board 662 are oriented so as to intersect with each other, as shown in FIGS. 14 and 15. In more detail, the plate surfaces of the first circuit board 661 face the opposite sides in the second horizontal direction Y. The plate surfaces of the second circuit board 662 faces the opposite sides in the upward-downward direction Z. The first circuit board 661 is disposed above the end of the second circuit board 662 at the other side in the second horizontal direction, that is, the -Y-side with a gap between the two circuit boards. In the present embodiment, the first circuit board 661 and the second circuit board 662 are arranged along an L-letter shape when viewed in the first horizontal direction X.

In the present embodiment, a "first direction" perpendicular to the plate surfaces of the first circuit board 661 is the second horizontal direction Y. A "second direction" perpendicular to the first direction is the upward-downward direction Z. A "third direction" perpendicular to both the first and second directions is the first horizontal direction X.

A first connector 671 and a second connector 672 of a connector unit 670 are coupled to each other in the upward-downward direction Z. The first connector 671 is located above the second connector 672. The first connector 671 is the same as the first connector 71 in the first embodiment except that the first circuit board 661 to which the first connector 671 is attached is differently oriented. The first connector 671 includes a first housing 671a, which is a holder, and first couplers 671b held by the first housing 671a, as shown in FIG. 15. The first couplers 671b each include a first extending section 671c, a second extending section 671d, and a board connecting section 671e. The first extending section 671c extends in the upward-downward direction Z. A lower end portion of the first extending section 671c is exposed in a recess that is not shown but is formed in the first housing 671a and opens downward. An upper end portion of the first extending section 671c protrudes upward from the first housing 671a and is exposed to the exterior of the first housing 671a. The first couplers 671b of the first connector 671 thus protrude upward from the first housing 671a.

The second extending section 671d extends from the upper end of the first extending section 671c toward the other side in the second horizontal direction, that is, the -Y side and obliquely upward. The board connecting section 671e extends upward from the end of the second extending section 671d at the other side in the second horizontal direction. The board connecting section 671e is electrically coupled to a corresponding signal line 661d formed at the surface of the first circuit board 661 at the one side in the second horizontal direction, that is, the +Y side.

The second connector 672 includes a second housing 672a, which is a holder, and second couplers 672b held by the second housing 672a. The second couplers 672b each include a first extending section 672c, a second extending section 672d, a third extending section 672f, and a board connecting section 672e. The first extending section 672c extends in the second horizontal direction Y. An end portion of the first extending section 672c at the one side in the second horizontal direction, that is, the +Y side protrudes from the second housing 672a toward the one side in the second horizontal direction and is exposed to the exterior of the second housing 672a. The second couplers 672b of the second connector 672 thus protrude from the second housing 672a in the second horizontal direction Y. The second extending section 672d extends from the end of the first extending section 672c at the one side in the second horizontal direction obliquely downward toward the one side in the second horizontal direction. The board connecting section 672e extends from the lower end of the second extending section 672d toward the one side in the second horizontal direction. The board connecting section 672e is electrically coupled to a corresponding signal line 662d formed at the upper surface of the second circuit board 662.

The third extending section 672f extends upward from the end of the first extending section 672c at the other side in the second horizontal direction, that is, the -Y side. An upper end portion of the third extending portion 672f is inserted into a recess that is not shown but is formed in the first housing 671a, and is in contact with the first extending section 671c of the corresponding first coupler 671b that is exposed in the recess. The first couplers 671b and the second couplers 672b are thus electrically coupled to each other.

A metal member 680 is a sheet metal member, as shown in FIG. 14. The metal member 680 includes a cover section 680a and fixing sections 682a, 682b, 682c, and 682d. The cover section 680a includes a facing wall section 681 and bent sections 684. The facing wall section 681 includes a first section 681a and a second section 681b. The first section 681a and the second section 681b are linked to each other and bent with respect to each other.

The first section 681a is a portion that faces the connector unit 670 in the second horizontal direction Y perpendicular to the plate surfaces of the first circuit board 661. In the present embodiment, the first section 681a has the shape of a substantially rectangular plate having plate surfaces that face the opposite sides in the second horizontal direction Y and elongated in the first horizontal direction X. The first section 681a is located at a position shifted from the first connector 671 and the second connector 672 toward the one side in the second horizontal direction, that is, the +Y side, and faces the first connector 671 and the second connector 672 with a gap between the first section 681a and the two connectors in the second horizontal direction Y.

The first section 681a faces a first side surface 671g of the first connector 671 out of the side surfaces thereof, as shown in FIG. 15. The first side surface 671g is a surface of the first housing 671a at the one side in the second horizontal direction, that is, the +Y side. The first section 681a also faces a side surface 672g of the second housing 672a at the one side in the second horizontal direction. In the present embodiment, the first section 681a covers the entire connector unit 670 except for a lower end portion of the second connector 672 from the one side in the second horizontal direction. The first section 681a is located above and away from the second circuit board 662. The lower end of the first section 681a is located below the first extending sections 672c but above the board connecting sections 672e. The first section 681a overlaps with the first circuit board 661 when viewed in the second horizontal direction Y perpendicular to the plate surfaces of the first circuit board 661, and overlaps with the second circuit board 662 when viewed in the upward-downward direction Z perpendicular to the plate surfaces of the second circuit board 662.

The first section 681a is located at a position shifted from the board connection sections 672e toward the one side in the second horizontal direction, that is, the +Y side. In the present embodiment, the first section 681a is an end portion of the facing wall section 681 at the one end in the second horizontal direction. That is, the end portion of the facing wall section 681 at the side where the second couplers 672b protrude from the second housing 672a, which is a holder, that is, the +Y side is located outside the ends of the second couplers 672b at the side where the second couplers 672b protrude from the second housing 672a.

The distance in the second horizontal direction Y between the first section 681a and the first housing 671a of the first connector 671 is, for example, smaller than the dimension of the connector unit 670 in the upward-downward direction Z. The distance in the second horizontal direction Y between the first section 681a and the first housing 671a is, for example, smaller than the dimension of the first connector 671 in the upward-downward direction Z and the dimension of the second connector 672 in the upward-downward direction Z. The distance in the second horizontal direction Y between the first section 681a and the first housing 671a is, for example, greater than or equal to about 0.5 mm but smaller than or equal to about 20 mm. The distance in the second horizontal direction Y between the first section 681a and the first housing 671a is preferably, for example, smaller than 10 mm. The distance in the second horizontal direction Y between the first section 681a and the first housing 671a is similar to the distance in the second horizontal direction Y between the first section 681a and the second housing 672a.

The second section 681b is a portion that faces the connector unit 670 in the upward-downward direction Z perpendicular to the plate surfaces of the second circuit board 662. In the present embodiment, the second section 681b has the shape of a substantially rectangular plate having plate surfaces that face the opposite sides in the upward-downward direction Z and elongated in the first horizontal direction X, as shown in FIG. 14. The second section 681b protrudes from the upper end of the first section 681a toward the other side in the second horizontal direction, that is, the -Y side. In the present embodiment, the second section 681b is a portion bent at the upper end of the first section 681a toward the other side in the second horizontal direction, that is, the -Y side.

The second section 681b is located above the first connector 671 and faces the first connector 671 in the upward-downward direction Z with a gap therebetween. The second section 681b faces a second side surface 671h different from the first side surface 671g out of the side surfaces of the first connector 671, as shown in FIG. 15. The second side surface 671h is the upper side surface of the first housing 671a. In the present embodiment, the second section 681b covers the entire connector unit 670 from above except for an end portion of the first connector 671 at the other side in the second horizontal direction, that is, the -Y side. The second section 681b is located away from the first circuit board 661 toward the one side in the second horizontal direction, that is, the +Y side. The end of the second section 681b at the other side in the second horizontal direction is located at a position shifted from the first extending sections 671c toward the other side in the second horizontal direction but shifted from the board connecting sections 671e toward the one side in the second horizontal direction. The second section 681b overlaps with the first circuit board 661 when viewed in the second horizontal direction Y perpendicular to the plate surfaces of the first circuit board 661, and overlaps with the second circuit board 662 when viewed in the upward-downward direction Z perpendicular to the plate surfaces of the second circuit board 662.

The second section 681b is located above the board connection sections 671e. In the present embodiment, the second section 681b is an upper end portion of the facing wall section 681. That is, the end portion of the facing wall section 681 at the side where the first couplers 671b protrude from the first housing 671a, which is a holder, that is, the upper side is located outside the ends of the first couplers 671b at the side where the first couplers 671b protrude from the first housing 671a.

The distance in the upward-downward direction Z between the second section 681b and the first housing 671a is, for example, smaller than the dimension of the connector unit 670 in the second horizontal direction Y. The distance in the upward-downward direction Z between the second section 681b and the first housing 671a is, for example, smaller than the distance in the second horizontal direction Y between the first section 681a and the first housing 671a. The distance in the upward-downward direction Z between the second section 681b and the first housing 671a is, for example, greater than or equal to about 0.5 mm but smaller than or equal to about 20 mm. The distance in the upward-downward direction Z between the second section 681b and the first housing 671a is preferably, for example, smaller than 10 mm.

The bent sections 684 are bent portions of the first section 681a and link the first section 681a to first coupling sections 685a, as shown in FIG. 14. In the present embodiment, the bent sections 684 are bent portions of the first section 681a that extend toward the other side in the second horizontal direction, that is, the -Y side. In the present embodiment, the bent sections 684 each have the shape of a substantially rectangular plate having plate surfaces that face the opposite sides in the first horizontal direction X and elongated in the second horizontal direction Y. The bent sections 684 include a pair of bent sections 684a and 684b. The bent section 684a extends from the edge of the first section 681a at the one side in the first horizontal direction, that is, the +X side toward the other side in the second horizontal direction. The bent section 684b extends from the edge of the first section 681a at the other side in the first horizontal direction, that is, the -X side toward the other side in the second horizontal direction. The pair of bent sections 684a and 684b are disposed to sandwich the connector unit 670 in the first horizontal direction X. The bent section 684a links the first section 681a to the first coupling section 685a of the fixing section 682a. The bent section 684b links the first section 681a to the first coupling section 685a of the fixing section 682b.

The fixing sections 682a and 682b are portions fixed to the first circuit board 661. The fixing section 682a includes the first coupling section 685a and a tubular section 682j. The first coupling section 685a has the shape of a substantially rectangular plate having plate surfaces that face the opposite sides in the second horizontal direction Y and elongated in the upward-downward direction Z. The first coupling section 685a of the fixing section 682a protrudes from the end of the bent section 684a at the other side in the second horizontal direction, that is, the -Y side toward the one side in the first horizontal direction, that is, the +X side. The first coupling section 685a of the fixing section 682a is electrically coupled to the first ground layer 61g via a first ground pad 661i. The tubular section 682j has a tubular shape protruding from the first coupling section 685a toward the one side in the second horizontal direction, that is, the +Y side. The fixing section 682a has a female threaded hole 682h formed therein, which passes through the first coupling section 685a and the tubular section 682j in the second horizontal direction Y. A bolt 691, which fixes the fixing section 682a to the first circuit board 661, is screwed into the female threaded hole 682h from the other side in the second horizontal direction, that is, the -Y side.

The fixing section 682b is so disposed that the fixing section 682b and the fixing section 682a are symmetrical along the first horizontal direction X. The first coupling section 685a of the fixing section 682b protrudes from the end of the bent section 684b at the other side in the second horizontal direction toward the other side in the first horizontal direction, that is, the -X side. The first coupling section 685a of the fixing section 682b is electrically coupled to the first ground layer 61g via a first ground pad 661j. Other configurations of the fixing section 682b are the same as those of the fixing section 682a.

The fixing sections 682c and 682d are portions fixed to the second circuit board 662. The fixing section 682c includes a second coupling section 685b, a tubular section 682r, and a coupling arm section 682k. The coupling arm section 682k is linked to a lower end portion of the edge of the first section 681a at the one side in the first horizontal direction, that is, the +X side. The coupling arm section 682k protrudes downward from the first section 681a. In the present embodiment, the coupling arm section 682k has the shape of a substantially rectangular plate having plate surfaces that face the opposite sides in the second horizontal direction Y.

The second coupling section 685b of the fixing section 682c protrudes from the lower end of the coupling arm section 682k toward the one side in the second horizontal direction, that is, the +Y side. The second coupling section 685b has the shape of a substantially square plate having plate surfaces that face the opposite sides in the upward-downward direction Z. The second coupling section 685b of the fixing section 682c is electrically coupled to the second ground layer 62g via a second ground pad 662i. In the present embodiment, the first coupling sections 685a and the second coupling sections 685b are not directly linked to each other. That is, the first coupling sections 685a and the second coupling sections 685b are separate from each other. The tubular section 682r has a tubular shape protruding upward from the second coupling section 685b. The fixing section 682c has a female threaded hole 682p formed therein, which passes through the second coupling section 685b and the tubular section 682r in the upward-downward direction Z. A bolt 692, which fixes the fixing section 682c to the second circuit board 662, is screwed into the female threaded hole 682p from below.

The fixing section 682d is so disposed that the fixing section 682d and the fixing section 682c are symmetrical along the first horizontal direction X. The fixing section 682d is linked to a lower end portion of the edge of the first section 681a at the other side in the first horizontal direction, that is, the -X side. The second coupling section 685b of the fixing section 682d is electrically coupled to the second ground layer 62g via a second ground pad 662j. Other configurations of the fixing section 682d are the same as those of the fixing section 682c.

A current Is2 flows and a signal is therefore transmitted between the first circuit board 661 and the second circuit board 662 via the connector unit 670. In the example shown in FIG. 15, the current Is2 flowing from the first circuit board 661 to the second circuit board 662 is indicated with the broken-line arrows. The current Is2 flows from the signal lines 661d formed in the first circuit board 661 to the signal lines 662d formed in the second circuit board 662 through the first couplers 671b and the second couplers 672b in this order. When the current Is2 flows as described above, a return current Ir4 corresponding to the current Is2 flows.

The return current Ir4 indicated by the broken-line arrows in the example shown in FIG. 15 is a return current flowing from the second ground layer 62g of the second circuit board 662 to the first ground layer 61g of the first circuit board 661. The return current Ir4 flows through the portion of the second ground layer 62g that is located below of the signal lines 662d in the opposite direction of the direction of the current Is2, and then flows from the second ground layer 62g to the first section 681a of the facing wall section 681. Although the second ground layer 62g and the first section 681a are not coupled to each other via a conductor, the return current Ir4 generated in response to the current Is2, which is a high-frequency current, can propagate from the second ground layer 62g to the first section 681a with the aid of spatial capacitive coupling. The return current Ir4 having flowed through the first section 681a flows from the first section 681a to the second section 681b, and flows from the second section 681b to the first ground layer 61g of the first circuit board 661. Although the second section 681b and the first ground layer 61g are also not coupled to each other via a conductor, the return current Ir4 generated in response to the high-frequency current Is2 can propagate from the second section 681b to the first ground layer 61g with the aid of spatial capacitive coupling. The return current Ir4 having flowed to the first ground layer 61g flows in the opposite direction of the direction of the current Is2 through the portion of the first ground layer 61g that is shifted from the signal lines 661d toward the other side of in the second horizontal direction. As described above, in the present embodiment, a return path along which the return current Ir4 generated when the current Is2 flows through the connector unit 670 flows is formed by the metal member 680. Note that when the current Is2 flows from the second circuit board 662 to the first circuit board 661, the return current Ir4 flows in the opposite direction of the direction indicated with the broken-line arrows shown in FIG. 15, and flows from the first ground layer 61g to the second ground layer 62g.

According to the present embodiment, the plate surfaces of the first circuit board 661 and the plate surfaces of the second circuit board 662 are oriented so as to intersect with each other. The facing wall section 681 includes the first section 681a, which faces the connector unit 670 in the second horizontal direction Y perpendicular to the plate surfaces of the first circuit board 661, and the second portion 681b, which faces the connector unit 670 in the upward-downward direction Z perpendicular to the plate surfaces of the second circuit board 662. The facing wall section 681 can therefore be preferably disposed with respect to the connector unit 670, which couples the first circuit board 661 and the second circuit board 662 to each other, which are so disposed that the plate surfaces thereof intersect with each other, and the return path along which the return current Ir4 passes through the facing wall section 681 can be formed. The unwanted radiation noise caused by the current flowing through the connector unit 670 can therefore be preferably suppressed. Furthermore, since the connector unit 670 can be covered in two different directions with the first section 681a and the second section 681b, the electromagnetic waves generated from the connector unit 670 can be preferably blocked by the facing wall section 681. The configuration described above can therefore suppress leakage of the electromagnetic waves generated from the connector unit 670 to the exterior of the circuit board unit 660.

According to the present embodiment, the first section 681a and the second section 681b are linked to each other and bent with respect to each other. The first section 681a and the second section 681b can therefore be readily formed by bending the facing wall section 681. The unwanted radiation noise caused by the current flowing through the connector unit 670 can therefore be preferably suppressed with the structure of the facing wall section 681 simplified.

According to the present embodiment, the first coupling sections 685a and the second coupling sections 685b are separate from each other. The portions to which the coupling sections are coupled in each of the circuit boards can therefore be arranged with improved flexibility, as compared with a case where each of the first coupling sections 685a is linked to the corresponding one of the second coupling sections 685b. The portions to which the coupling sections are coupled can therefore be preferably disposed on each of the circuit boards in accordance with the electronic elements and the wiring patterns mounted on the circuit board.

In the present embodiment, the first section 681a may be regarded as the "facing wall section", the second section 681b may be regarded as the "protruding wall section", and the bent sections 684 may be regarded as the "coupling wall sections". In this case, the bent sections 684, which are the coupling wall sections, link only the first coupling sections 685a out of the first coupling sections 685a and the second coupling sections 685b to the first section 681a, which is the facing wall section.

Embodiments of the present disclosure are not limited to the embodiments described above, and the following configurations and methods can be employed. The metal member may have any configuration including a first coupling section, a second coupling section, and a cover section. The number of first coupling sections and the number of second coupling sections are each not particularly limited to a specific number and may be one or more. For example, in the first embodiment described above, only one of the fixing sections 82a and 82b may be provided. The coupling sections may each be coupled to each of the circuit boards in any manner. The coupling sections may each be soldered to each of the circuit boards. The cover section may have any configuration including a facing wall section. The entire facing wall section may face the connector unit. In the sixth embodiment described above, the facing wall section 681 may be configured with the first section 681a, and the second section 681b may not be provided.

The connector unit may have any configuration including a first connector and a second connector coupled to each other. The first connector and the second connector may be coupled to each other in any manner. The first circuit board and the second circuit board may each have any configuration including a ground layer. The first circuit board and the second circuit board may be disposed in any manner. The first circuit board and the second circuit board may each be a flexible substrate.

The aforementioned first embodiment has been described with reference to the case where the present disclosure is applied to a transmissive projector, and the present disclosure is also applicable to a reflective projector. The term "transmissive" means that the liquid crystal light valves including liquid crystal panels or the like transmit light. The term "reflective" means that the liquid crystal light valves reflect light. Note that the light modulators are not limited to liquid crystal panels or the like, and may each, for example, be a light modulator using micromirrors.

The aforementioned first embodiment has been described with reference to the projector 1 using the three light modulators 4R, 4G, and 4B, and the present disclosure is also applicable to a projector using only one light modulator and a projector using four or more light modulators.

The electronic instrument that incorporates the circuit boards and the electronic instrument that incorporates the circuit board unit are each not limited to a projector, and may be any other electronic instrument.

The configurations and methods described in the present specification can be combined with each other as appropriate to the extent that no contradiction occurs.

### Summary of present disclosure

The present disclosure will be summarized below as additional remarks.

### Additional remark 1

A circuit board unit including:
a first circuit board including a first ground layer;
a second circuit board including a second ground layer;
a connector unit including a first connector attached to the first circuit board and a second connector attached to the second circuit board; and
a metal member configured to couple the first circuit board and the second circuit board to each other,
wherein the metal member includes
a first coupling section electrically coupled to the first ground layer,
a second coupling section electrically coupled to the second ground layer, and
a cover section configured to cover at least a part of the connector unit,
the cover section includes a facing wall section at least a part of which faces the connector unit in a direction perpendicular to plate surfaces of the first circuit board, and
the facing wall section overlaps with the first circuit board when viewed in the direction perpendicular to the plate surfaces of the first circuit board, and overlaps with the second circuit board when viewed in a direction perpendicular to plate surfaces of the second circuit board.

According to the configuration described above, a return current is readily allowed to propagate between the first ground layer of the first circuit board and the facing wall section and between the second ground layer of the second circuit board and the facing wall section with the facing wall section disposed in the vicinity of the connector unit. The metal member can thus preferably provide the return path along which the return current flows between the first circuit board and the second circuit board. The electromagnetic field generated by the return current flowing through the metal member can therefore preferably cancel the electromagnetic field generated by the current flowing through the connector unit. Unwanted radiation noise caused by the current flowing through the connector unit, which links the first circuit board and the second circuit board to each other, can therefore be preferably suppressed. In other words, since the energy of the current flowing through the connector unit and the energy of the return current are balanced, and excessive energy is therefore unlikely to be generated, so that the unwanted radiation noise caused by the otherwise excessive energy can be preferably suppressed.

Since the metal member includes the first coupling section and the second coupling section, the first ground layer of the first circuit board and the second ground layer of the second circuit board can be electrically coupled to each other via the metal member. The potential at each of the ground layers can therefore be more preferably stabilized. The unwanted radiation noise caused by the current flowing through signal lines and the like along each of the ground layers can therefore be more preferably suppressed.

In addition, the metal member can provide the connector unit with a return current path, such as the first ground layer and the second ground layer. Therefore, even when couplers of the connector unit are separate from the circuit boards, the metal member can provide the couplers separate from the circuit boards with a return current path. The path of the return current for the couplers and wiring layers provided in the circuit boards can therefore be shortened, as compared with a case where the metal member is not provided. The path of the return current for the couplers can therefore be readily designed, so that deterioration of the quality of signals flowing through the couplers can be suppressed.

Covering at least a part of the connector unit with the cover section of the metal member allows the cover section to block at least part of the electromagnetic waves generated from the connector unit. The configuration described above can therefore suppress leakage of the electromagnetic waves generated from the connector unit to the exterior of the circuit board unit.

### Additional remark 2

The circuit board unit according to the additional remark 1, wherein
the cover section includes a first protruding wall section protruding from the facing wall section toward one of the first circuit board and the second circuit board, and
the first protruding wall section faces the connector unit in a second direction perpendicular to a first direction perpendicular to the plate surfaces of the first circuit board.

According to the configuration described above, the first protruding wall section is allowed to be close to the first ground layer of the first circuit board or the second ground layer of the second circuit board. The return current is thus allowed to readily propagate between the first ground layer or the second ground layer and the metal member. The return current is therefore allowed to more preferably flow to the metal member, so that the unwanted radiation noise caused by the current flowing through the connector unit can be more preferably suppressed. Furthermore, since the connector unit can be covered in the second direction with the first protruding wall section, part of the electromagnetic waves generated from the connector unit can be blocked by the first protruding wall section. The configuration described above can therefore suppress leakage of the electromagnetic waves generated from the connector unit to the exterior of the circuit board unit by a greater degree.

### Additional remark 3

The circuit board unit according to the additional remark 2, wherein
the cover section includes a second protruding wall section protruding from the facing wall section toward another of the first circuit board and the second circuit board,
the first and second protruding wall sections are provided to sandwich the connector unit in the second direction,
the first protruding wall section protrudes from the facing wall section toward the first circuit board, and
the second protruding wall section protrudes from the facing wall section toward the second circuit board.

According to the configuration described above, the first protruding wall section can be disposed so as to be close to the first ground layer, and the second protruding wall section can be disposed so as to be close to the second ground layer. The return current is thus allowed to readily propagate both between the first ground layer and the metal member and the second ground layer and the metal member. The return current is therefore allowed to more preferably flow to the metal member, so that the unwanted radiation noise caused by the current flowing through the connector unit can be more preferably suppressed.

### Additional remark 4

The circuit board unit according to the additional remark 2 or 3, wherein a gap is provided between the first protruding wall section and the one circuit board.

According to the configuration described above, signal lines coupled to the connector unit can be formed in a portion of a plate surface of the one circuit board, the portion facing the first protruding wall section. Complication of wiring patterns formed at the one circuit board can thus be suppressed.

### Additional remark 5

The circuit board unit according to the additional remark 2 or 3, wherein the first protruding wall section is in contact with the one circuit board.

According to the configuration described above, the first protruding wall section can be preferably disposed so as to be close to the ground layer of the one circuit board. The return current is therefore allowed to more readily flow between the first protruding wall section and the ground layer.

### Additional remark 6

The circuit board unit according to the additional remark 5, wherein the first protruding wall section is electrically coupled to a ground layer provided in the one circuit board out of the first ground layer and the second ground layer via a ground pad formed at a plate surface of the one circuit board.

According to the configuration described above, the ground layer provided in the one circuit board and the metal member can be electrically coupled to each other. The return current is therefore allowed to more preferably flow between the first protruding wall section and the ground layer.

### Additional remark 7

The circuit board unit according to the additional remark 5 or 6, wherein
the connector unit includes a coupler electrically coupled to the one circuit board, and
the coupler is electrically coupled to a signal line provided at a plate surface opposite a plate surface to which the coupler is coupled out of the plate surfaces of the one circuit board or a signal line provided in an inner layer of the one circuit board via a conductive section formed in the one circuit board.

According to the configuration described above, even when the first protruding wall section is brought into contact with the one circuit board, the coupler can be preferably coupled to the signal line.

### Additional remark 8

The circuit board unit according to any one of the additional remarks 2 to 7, wherein
the cover section includes a first coupling wall section configured to link at least one of the first coupling section and the second coupling section to the facing wall section, and
the first coupling wall section faces the connector unit in a third direction perpendicular to both the first and second directions.

According to the configuration described above, the first coupling wall sections can link at least one of the first coupling section and the second coupling section to the facing wall section to support the facing wall section. The facing wall section can therefore be preferably disposed at a position where the facing wall section faces the connector unit in the first direction. Furthermore, since the connector unit can be covered in the third direction with the first coupling wall section, part of the electromagnetic waves generated from the connector unit can be blocked by the first coupling wall section. The configuration described above can therefore suppress leakage of the electromagnetic waves generated from the connector unit to the exterior of the circuit board unit by a greater degree.

### Additional remark 9

The circuit board unit according to the additional remark 8, wherein
the cover section includes a second coupling wall section disposed at a side opposite the first coupling wall section and linked to the facing wall section, and
the first and second coupling wall sections are provided to sandwich the connector unit in the third direction.

According to the configuration described above, the facing wall section can be supported by the first and second coupling wall sections. The facing wall section can therefore be more stably disposed with respect to the connector unit. Furthermore, since a situation in which the facing wall section is supported in the form of a cantilever in the third direction can be suppressed, a situation in which an end portion of the facing wall section in the third direction electrically vibrates can be suppressed. A situation in which the facing wall section serves as an antenna that radiates the unwanted radiation noise can thus be suppressed.

### Additional remark 10

The circuit board unit according to the additional remark 8 or 9, wherein
the metal member is a sheet metal member,
the first protruding wall section is a portion bent in the first direction at an edge of the facing wall section that faces a side in the second direction, and
the first coupling wall section is a portion bent in the first direction at an edge of the facing wall section that faces a side in the third direction.

According to the configuration described above, creating the first protruding wall section and the first coupling wall section by bending the facing wall section readily allows individual adjustment of the dimension of the first protruding wall section in the first direction and the dimension of the first coupling wall section in the first direction. The cover section can therefore be readily created in accordance, for example, with the dimension of the connector unit in the first direction.

### Additional remark 11

The circuit board unit according to the additional remark 10, wherein
the cover section includes a bent section bent in the second direction at an edge of the first protruding wall section that faces a side in the third direction, and
at least a part of the bent section is disposed between the first coupling wall section and the connector unit in the third direction.

According to the configuration described above, at least a part of the gap between the first protruding wall section and the first coupling wall section, which is created when the first protruding wall section and the first coupling wall section are created by bending the facing wall section, can be closed by the bent section. The connector unit can thus be more suitably covered with the cover section, so that leakage of the electromagnetic waves generated from the connector unit to the exterior of the circuit board unit can be further suppressed.

### Additional remark 12

The circuit board unit according to any one of the additional remarks 1 to 11, wherein
plate surfaces of the first circuit board and plate surfaces of the second circuit board are parallel to each other, and
the first and second circuit boards are arranged side by side in a direction along the plate surfaces of the first circuit board and the plate surfaces of the second circuit board.

According to the configuration described above, the connector unit, which couples the first circuit board and the second circuit board to each other, is preferably covered with the cover section with the metal member having a relatively simple structure.

### Additional remark 13

The circuit board unit according to the additional remark 1, wherein
the plate surfaces of the first circuit board and the plate surfaces of the second circuit board are oriented so as to intersect with each other, and
the facing wall section includes
a first section facing the connector unit in a direction perpendicular to the plate surfaces of the first circuit board, and
a second section facing the connector unit in a direction perpendicular to the plate surfaces of the second circuit board.

According to the configuration described above, the facing wall section can be preferably disposed with respect to the connector unit, which couples the first circuit board and the second circuit board to each other, which are so disposed that the plate surfaces thereof intersect with each other, and the return path along which the return current passes through the facing wall section can be formed. The unwanted radiation noise caused by the current flowing through the connector unit can therefore be preferably suppressed. Furthermore, since the connector unit can be covered in two different directions with the first and second sections, the electromagnetic waves generated from the connector unit can be preferably blocked by the facing wall section. The configuration described above can therefore suppress leakage of the electromagnetic waves generated from the connector unit to the exterior of the circuit board unit.

### Additional remark 14

The circuit board unit according to the additional remark 13, wherein the first and second sections are coupled to each other and bent with respect to each other.

According to the configuration described above, the first and second sections can be readily formed by bending the facing wall section. The unwanted radiation noise caused by the current flowing through the connector unit can therefore be preferably suppressed with the structure of the facing wall section simplified.

### Additional remark 15

The circuit board unit according to any one of the additional remarks 1 to 14, wherein the first and second coupling sections are separate from each other.

According to the configuration described above, the portions to which the coupling sections are coupled in each of the circuit boards can be arranged with improved flexibility, as compared with a case where the first and second coupling sections are linked to each other. The portions to which the coupling sections are coupled can therefore be preferably disposed on each of the circuit boards in accordance with the electronic elements and the wiring patterns mounted on the circuit board.

### Additional remark 16

The circuit board unit according to any one of the additional remarks 1 to 14, wherein the first and second coupling sections are linked to each other.

According to the configuration described above, complication of the structure of the metal member can be suppressed as compared with a case where the first and second coupling sections are separately provided. Furthermore, the first and second ground layers can be electrically coupled to each other via the first and second coupling sections linked to each other. The first and second ground layers are therefore more preferably readily electrically coupled to each other.

### Additional remark 17

The circuit board unit according to any one of the additional remarks 1 to 16, wherein
a coupler of the first connector protrudes from a holder of the first connector that is configured to hold the coupler,
the facing wall section faces the coupler and the holder in a direction perpendicular to the plate surfaces of the first circuit board, and
an end of the facing wall section at a side where the coupler protrudes from the holder is located outside an end of the coupler at a side where the coupler protrudes from the holder.

According to the configuration described above, the first connector is preferably readily covered in the first direction with the facing wall portion. Furthermore, when the first protruding wall section, which protrudes toward the first circuit board, is provided at the end of the facing wall section at the side where the first coupler protrudes from the holder of the first connector, the first protruding wall section can be disposed at a position where the first protruding wall section does not overlap with the first coupler in the first direction. The first protruding wall section is therefore allowed to be preferably close to the first circuit board while a situation in which the first protruding wall section comes into contact with the first coupler is suppressed. The return current is therefore allowed to more readily flow between the first protruding wall section and the first ground layer.

### Additional remark 18

An electronic instrument including the circuit board unit according to any one of the additional remarks 1 to 17.

According to the configuration described above, the unwanted radiation noise caused by the current flowing through the connector unit can be preferably suppressed in the electronic instrument.

## Claims

1. A circuit board unit comprising:
a first circuit board including a first ground layer;
a second circuit board including a second ground layer;
a connector unit including a first connector attached to the first circuit board and a second connector attached to the second circuit board; and
a metal member configured to couple the first circuit board and the second circuit board to each other,
wherein the metal member includes
a first coupling section electrically coupled to the first ground layer,
a second coupling section electrically coupled to the second ground layer, and
a cover section configured to cover at least a part of the connector unit,
the cover section includes a facing wall section at least a part of which faces the connector unit in a direction perpendicular to plate surfaces of the first circuit board, and
the facing wall section overlaps with the first circuit board when viewed in the direction perpendicular to the plate surfaces of the first circuit board, and overlaps with the second circuit board when viewed in a direction perpendicular to plate surfaces of the second circuit board.

2. The circuit board unit according to claim 1, wherein
the cover section includes a first protruding wall section protruding from the facing wall section toward one of the first circuit board and the second circuit board, and
the first protruding wall section faces the connector unit in a second direction perpendicular to a first direction perpendicular to the plate surfaces of the first circuit board.

3. The circuit board unit according to claim 2, wherein
the cover section includes a second protruding wall section protruding from the facing wall section toward another of the first circuit board and the second circuit board,
the first and second protruding wall sections are provided to sandwich the connector unit in the second direction,
the first protruding wall section protrudes from the facing wall section toward the first circuit board, and
the second protruding wall section protrudes from the facing wall section toward the second circuit board.

4. The circuit board unit according to claim 2, wherein
a gap is provided between the first protruding wall section and the one circuit board.

5. The circuit board unit according to claim 2, wherein
the first protruding wall section is in contact with the one circuit board.

6. The circuit board unit according to claim 5, wherein
the first protruding wall section is electrically coupled to a ground layer provided in the one circuit board out of the first ground layer and the second ground layer via a ground pad formed at a plate surface of the one circuit board.

7. The circuit board unit according to claim 5, wherein
the connector unit includes a coupler electrically coupled to the one circuit board, and
the coupler is electrically coupled to a signal line provided at a plate surface opposite a plate surface to which the coupler is coupled out of the plate surfaces of the one circuit board or a signal line provided in an inner layer of the one circuit board via a conductive section formed in the one circuit board.

8. The circuit board unit according to claim 2, wherein
the cover section includes a first coupling wall section configured to link at least one of the first coupling section and the second coupling section to the facing wall section, and
the first coupling wall section faces the connector unit in a third direction perpendicular to both the first and second directions.

9. The circuit board unit according to claim 8, wherein
the cover section includes a second coupling wall section disposed at a side opposite the first coupling wall section and linked to the facing wall section, and
the first and second coupling wall sections are provided to sandwich the connector unit in the third direction.

10. The circuit board unit according to claim 8, wherein
the metal member is a sheet metal member,
the first protruding wall section is a portion bent in the first direction at an edge of the facing wall section that faces a side in the second direction, and
the first coupling wall section is a portion bent in the first direction at an edge of the facing wall section that faces a side in the third direction.

11. The circuit board unit according to claim 10, wherein
the cover section includes a bent section bent in the second direction at an edge of the first protruding wall section that faces a side in the third direction, and
at least a part of the bent section is disposed between the first coupling wall section and the connector unit in the third direction.

12. The circuit board unit according to claim 1, wherein
plate surfaces of the first circuit board and plate surfaces of the second circuit board are parallel to each other, and
the first and second circuit boards are arranged side by side in a direction along the plate surfaces of the first circuit board and the plate surfaces of the second circuit board.

13. The circuit board unit according to claim 1, wherein
the plate surfaces of the first circuit board and the plate surfaces of the second circuit board are oriented so as to intersect with each other, and
the facing wall section includes
a first section facing the connector unit in a direction perpendicular to the plate surfaces of the first circuit board, and
a second section facing the connector unit in a direction perpendicular to the plate surfaces of the second circuit board.

14. The circuit board unit according to claim 13, wherein
the first and second sections are coupled to each other and bent with respect to each other.

15. The circuit board unit according to claim 1, wherein
the first and second coupling sections are separate from each other.

16. The circuit board unit according to claim 1, wherein
the first and second coupling sections are linked to each other.

17. The circuit board unit according to claim 1, wherein
a coupler of the first connector protrudes from a holder of the first connector that is configured to hold the coupler,
the facing wall section faces the coupler and the holder in a direction perpendicular to the plate surfaces of the first circuit board, and
an end of the facing wall section at a side where the coupler protrudes from the holder is located outside an end of the coupler at a side where the coupler protrudes from the holder.

18. An electronic instrument comprising the circuit board unit according to claim 1.
